(19) Europäisches Patentamt
European Patent Office
Office européen des brevets

(11) **EP 4 607 827 A1**

(12) **EUROPEAN PATENT APPLICATION**
published in accordance with Art. 153(4) EPC

(43) Date of publication:
**27.08.2025 Bulletin 2025/35**

(21) Application number: **23884889.9**

(22) Date of filing: **31.10.2023**

(51) International Patent Classification (IPC):
**H04L 1/00** (2006.01)

(52) Cooperative Patent Classification (CPC):
**H03M 13/11; H04L 1/00**

(86) International application number:
**PCT/CN2023/128092**

(87) International publication number:
**WO 2024/093959 (10.05.2024 Gazette 2024/19)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **31.10.2022   CN 202211350638
22.11.2022   CN 202211467840**

(71) Applicant: **Huawei Technologies Co., Ltd.
Shenzhen, Guangdong 518129 (CN)**

(72) Inventors:
• **LIN, Wei
Shenzhen, Guangdong 518129 (CN)**

• **HUANG, Lei
Shenzhen, Guangdong 518129 (CN)**
• **QIAN, Bin
Shenzhen, Guangdong 518129 (CN)**
• **LIU, Chenchen
Shenzhen, Guangdong 518129 (CN)**
• **YANG, Xun
Shenzhen, Guangdong 518129 (CN)**

(74) Representative: **Körber, Martin Hans
Mitscherlich PartmbB
Patent- und Rechtsanwälte
Karlstraße 7
80333 München (DE)**

(54) **METHOD FOR DETERMINING LENGTH OF LDPC CODEWORD IN UWB SYSTEM, AND RELATED APPARATUS**

(57)    This application relates to a method for determining a length of an LDPC codeword in a UWB system and a related apparatus. The method includes: A communication apparatus determines an LDPC code length based on a length of a to-be-encoded information bit; and selects a 684-bit LDPC code when the length of the information bit is 0 to $L_1$; selects a 1296-bit LDPC code when the length of the information bit is $L_1$ to $L_2$; or selects a 1944-bit LDPC code when the length of the information bit is $L_2$ to 648. According to embodiments of this application, a better performance gain can be achieved, and a coding rate loss can be reduced. This application is applied to a UWB-based wireless personal local area network system, a sensing system, or the like, including an 802.15 series protocol, for example, the 802.15.4ab protocol or a next-generation UWB protocol of the 802.15.4ab protocol, and may be further applied to a wireless local area network system based on an 802.11 series protocol, for example, 802.11be or a next-generation protocol of 802.11be like Wi-Fi 8.

FIG. 7

EP 4 607 827 A1

S101

A communication apparatus obtains a length of a to-be-encoded information bit

The communication apparatus determines a length of an LDPC codeword based on the length of the to-be-encoded information bit, where a parity-check matrix corresponding to the LDPC codeword is used to encode the to-be-encoded information bit to generate a parity bit, and the length of the to-be-encoded information bit and the length of the LDPC codeword meet one or more of the following conditions: if the length of the to-be-encoded information bit is greater than 0 and less than or equal to a first length, the length of the LDPC codeword is 648 bits; if the length of the to-be-encoded information bit is greater than the first length and less than or equal to a second length, the length of the LDPC codeword is 1296 bits; or if the length of the to-be-encoded information bit is greater than the second length and less than or equal to a first value, the length of the LDPC codeword is 1944 bits

S102

FIG. 7

**Description**

This application claims priorities to Chinese Patent Application No. 202211350638.9, filed with the China National Intellectual Property Administration on October 31, 2022 and entitled "METHOD FOR DETERMINING LENGTH OF LDPC CODEWORD IN UWB SYSTEM AND RELATED APPARATUS", and to Chinese Patent Application No. 202211467840.X, filed with the China National Intellectual Property Administration on November 22, 2022 and entitled "METHOD FOR DETERMINING LENGTH OF LDPC CODEWORD IN UWB SYSTEM AND RELATED APPARATUS", both of which are incorporated herein by reference in their entireties.

**TECHNICAL FIELD**

This application relates to the field of communication technologies, and in particular, to a method for determining a length of a low-density parity-check (low-density parity-check, LDPC) codeword in an ultra-wideband (ultra-wideband, UWB) system and a related apparatus.

**BACKGROUND**

Wireless local area network (wireless local area network, WLAN) standards, such as Institute of Electrical and Electronics Engineers (institute of electrical and electronics engineers, IEEE) 802.11n/ac/ax/be, mainly study how to improve user experience in a 60 GHz high-bandwidth scenario, including increasing an average user throughput and improving energy utilization of a battery-based power supply device. To implement this, high-speed and reliable transmission of services, such as data and video services, needs to be implemented on limited frequency resources and power resources. Therefore, a highly reliable and efficient channel encoding and decoding scheme is required.

Currently, a turbo code and an LDPC code are two most commonly used channel coding schemes in the field of channel coding, and both have performance close to a Shannon (Shannon) limit, and have been widely used in the communication field. Compared with the turbo code, the LDPC code has significant advantages. For example, quite good bit error performance can be achieved without deep interleaving, better frame error rate performance is achieved, an error floor (error floor) is greatly lowered, parallel decoding is supported, and a decoding delay is short. Therefore, the LDPC code has become a standard channel coding scheme for low-frequency short-range WLAN communication systems such as 802.11n/ac/ax systems.

To improve transmission reliability of a wireless transmission system, the LDPC code is widely used in WLAN standards. In a next-generation UWB standard like the IEEE 802.15ab standard, the LDPC code used in a WLAN is to be introduced to improve data transmission reliability of a system. However, selection of a length of an LDPC codeword affects error control performance. Therefore, how to determine a length of an LDPC codeword in a UWB system urgently needs to be studied.

**SUMMARY**

Embodiments of this application provide a method for determining a length of an LDPC codeword in a UWB system and a related apparatus, to achieve a higher error control performance gain and reduce a coding rate loss.

The following describes this application from different aspects. It should be understood that, for the following implementations and advantageous effects of the different aspects, refer to each other.

According to a first aspect, this application provides a method for determining a length of an LDPC codeword in a UWB system. The method includes: A communication apparatus obtains a length of a to-be-encoded information bit, and determines a length of an LDPC codeword based on the length of the to-be-encoded information bit. A parity-check matrix corresponding to the LDPC codeword is used to encode the to-be-encoded information bit to generate a parity bit. That the communication apparatus determines the length of the LDPC codeword based on the length of the to-be-encoded information bit includes one or more of the following operations: If the length of the to-be-encoded information bit is greater than 0 and less than or equal to the first length, the communication apparatus determines that the length of the LDPC codeword is 648 bits; if the length of the to-be-encoded information bit is greater than the first length and less than or equal to the second length, the communication apparatus determines that the length of the LDPC codeword is 1296 bits; or if the length of the to-be-encoded information bit is greater than the second length and less than or equal to a first value, the communication apparatus determines that the length of the LDPC codeword is 1944 bits. The first value is 648 bits (or 81 bytes). At least one of the first length or the second length is determined based on a preset coding rate threshold.

For detailed analysis of beneficial effect of this application, refer to descriptions in the following method embodiments. Details are not described herein. In this application, a better error control performance gain can be obtained, and a coding rate loss can be reduced. In addition, it can be ensured that an effective coding rate of a short packet (for example, the length of the to-be-encoded information bit is less than or equal to 648 bits) is less than a given threshold, to improve short packet performance.

In this application, the to-be-encoded information bit is an information bit that has not undergone channel coding, namely, an information bit input to an input end of a channel coding module. For example, the to-be-encoded information bit may be a to-be-encoded data bit (namely, a payload bit), or the to-be-encoded information bit includes a to-be-encoded data bit and a CRC bit. This is not limited in embodiments of this application.

With reference to the first aspect, in a possible implementation, a reference coding rate of the LDPC codeword is 0.5.

With reference to the first aspect, in a possible implementation, the first length is determined based on a first codeword length, the reference coding rate of the LDPC codeword, and a first preset coding rate threshold. The first codeword length is 648 bits or 81 bytes. The first preset coding rate threshold is less than the reference coding rate of the LDPC codeword, that is, less than 0.5.

Optionally, a value range of the first preset coding rate threshold may be greater than or equal to 0.3 and less than or equal to 0.43.

Optionally, the first length satisfies:

$$L_1 = \left\lceil \frac{N_1 \times (1-R) \times Rth1}{1 - Rth1} \right\rceil_{Int},$$

where

$L_1$ indicates the first length, $N_1$ indicates the first codeword length (equal to 648 bits or 81 bytes), R indicates the reference coding rate (equal to 0.5) of the LDPC codeword, $Rth1$ indicates the first preset coding rate threshold (less than 0.5), and $[x]_{int}$ indicates rounding x.

A rounding operation in this application may be rounding to an integer number of bits or bytes, or may be rounding up or rounding down to an integer multiple of 5 bits or bytes, or may be rounding up or rounding down to an integer multiple of 10 bits or bytes.

With reference to the first aspect, in a possible implementation, the second length is determined based on a second codeword length, the reference coding rate of the LDPC codeword, and a second preset coding rate threshold. The second codeword length is 1296 bits or 162 bytes. The second preset coding rate threshold is less than the reference coding rate of the LDPC codeword, that is, less than 0.5.

Optionally, a value range of the second preset coding rate threshold may be greater than or equal to 0.3 and less than or equal to 0.43.

Optionally, the second length satisfies:

$$L_2 = \left\lceil \frac{N_2 \times (1-R) \times Rth2}{1 - Rth2} \right\rceil_{Int},$$

where

$L_2$ indicates the second length, $N_2$ indicates the second codeword length (equal to 1296 bits or 162 bytes), R indicates the reference coding rate (less than 0.5) of the LDPC codeword, $Rth2$ indicates the second preset coding rate threshold (less than 0.5), and $[x]_{int}$ indicates rounding x.

It may be understood that once the value ranges of the first preset coding rate threshold and the second preset coding rate threshold are determined, value ranges of the first length and the second length are determined.

With reference to the first aspect, in a possible implementation, the first preset coding rate threshold and the second preset coding rate threshold may be the same or may be different.

With reference to the first aspect, in a possible implementation, the length of the to-be-encoded information bit and the length of the LDPC codeword meet one or more of the following conditions: If the length of the to-be-encoded information bit is greater than the first value and less than or equal to a third length, the length of the LDPC codeword is 1944 bits; if the length of the to-be-encoded information bit is greater than the third length and less than or equal to a fourth length, the length of the LDPC codeword is 1296 bits; or if the length of the to-be-encoded information bit is greater than the fourth length, the length of the LDPC codeword is 1944 bits. At least one of the third length or the fourth length is determined based on a preset coding rate threshold.

Optionally, the third length is determined based on a third codeword length, the reference coding rate of the LDPC codeword, and a third preset coding rate threshold. The third codeword length is 1944 bits or 243 bytes. The third preset coding rate threshold is less than the reference coding rate of the LDPC codeword. For example, a value range of the third preset coding rate threshold may be greater than 0.4 and less than or equal to 0.5.

For example, the third length satisfies:

$$L_3 = \left\lceil \frac{N_3 \times (1-R) \times Rth3}{1 - Rth3} \right\rceil_{Int},$$

where

$L_3$ indicates the third length, $N_3$ indicates the third codeword length (equal to 1944 bits or 243 bytes), R indicates the reference coding rate (equal to 0.5) of the LDPC codeword, $Rth3$ indicates the third preset coding rate threshold (less than 0.5), and $[x]_{int}$ indicates rounding x.

Optionally, the fourth length is determined based on the second codeword length and a fourth preset coding rate threshold, and the fourth preset coding rate threshold is less than the reference coding rate of the LDPC codeword. For example, a value range of the fourth preset coding rate threshold may be greater than 0.4 and less than or equal to 0.5.

For example, the fourth length satisfies:

$$L_4 = \left\lceil \frac{N_2 \times Rth4}{1 - Rth4} \right\rceil_{Int},$$

where

$L_4$ indicates the fourth length, $N_2$ indicates the second codeword length (equal to 1296 bits or 162 bytes), $Rth4$ indicates the fourth preset coding rate threshold (less than 0.5), and $[x]_{int}$ indicates rounding x.

It may be understood that once the value ranges of the third preset coding rate threshold and the fourth preset coding rate threshold are determined, value ranges of the third length and the fourth length are determined.

With reference to the first aspect, in a possible implementation, the third preset coding rate threshold and the fourth preset coding rate threshold may be the same or may be different.

With reference to the first aspect, in a possible implementation, the method further includes: The communication apparatus transmits the LDPC codeword, where the LDPC codeword includes the to-be-encoded information bit and the parity bit. For example, the communication apparatus generates the LDPC codeword based on the determined length of the LDPC codeword, the to-be-encoded information bit, the reference coding rate of the LDPC codeword, and other information, and transmits the LDPC codeword.

With reference to the first aspect, in a possible implementation, a number of shortening zero bits in the LDPC codeword is determined based on the length of the to-be-encoded information bit and a number of information bits in the LDPC codeword. The number of information bits in the LDPC codeword is determined based on the length of the LDPC codeword and the reference coding rate.

For example, the number of shortening zero bits in the LDPC codeword is as follows:

$$Padding\_Num = mod(K - mod(Inf\_Num, K), K),$$

where

Padding_Num indicates the number of shortening zero bits in the LDPC codeword, K indicates the number of information bits in the LDPC codeword, Inf_Num indicates the length of the to-be-encoded information bit, and mod indicates a modulo operation. K=N×R, where N indicates the length of the LDPC codeword, and R indicates the reference coding rate of the LDPC codeword.

With reference to the first aspect, in a possible implementation, the to-be-encoded information bit includes a cyclic redundancy check (cyclic redundancy check, CRC) bit.

According to a second aspect, this application provides a communication apparatus, including an obtaining unit and a determining unit. The obtaining unit is configured to obtain a length of a to-be-encoded information bit. The determining unit is configured to determine a length of a low-density parity-check LDPC codeword based on the length of the to-be-encoded information bit, where a parity-check matrix corresponding to the LDPC codeword is used to encode the to-be-encoded information bit to generate a parity bit. The determining unit is specifically configured to perform one or more operations: when the length of the to-be-encoded information bit is greater than 0 and less than or equal to a first length, determining that the length of the LDPC codeword is 648 bits; when the length of the to-be-encoded information bit is greater than the first length and less than or equal to a second length, the communication apparatus determines that the length of the LDPC codeword is 1296 bits, and determines that the length of the LDPC codeword is 1296 bits; or when the length of the to-be-encoded information bit is greater than the second length and less than or equal to a first value, the communication apparatus determines that the length of the LDPC codeword is 1944 bits, and determines that the length of the LDPC codeword is 1944 bits. The first value is 648 bits (or 81 bytes). At least one of the first length or the second length is determined based on a preset coding rate threshold.

With reference to the second aspect, in a possible implementation, a reference coding rate of the LDPC codeword is 0.5.

With reference to the second aspect, in a possible implementation, the first length is determined based on a first codeword length, the reference coding rate of the LDPC codeword, and a first preset coding rate threshold. The first codeword length is 648 bits or 81 bytes. The first preset coding rate threshold is less than the reference coding rate of the LDPC codeword, that is, less than 0.5.

Optionally, a value range of the first preset coding rate threshold may be greater than or equal to 0.3 and less than or equal to 0.43.

Optionally, the first length satisfies:

$$L_1 = \left\lceil \frac{N_1 \times (1-R) \times Rth1}{1 - Rth1} \right\rceil_{Int},$$

where

$L_1$ indicates the first length, $N_1$ indicates the first codeword length (equal to 648 bits or 81 bytes), R indicates the reference coding rate (equal to 0.5) of the LDPC codeword, $Rth1$ indicates the first preset coding rate threshold (less than 0.5), and $[x]_{int}$ indicates rounding x.

A rounding operation in this application may be rounding to an integer number of bits or bytes, or may be rounding up or rounding down to an integer multiple of 5 bits or bytes, or may be rounding up or rounding down to an integer multiple of 10 bits or bytes.

With reference to the second aspect, in a possible implementation, the second length is determined based on a second codeword length, the reference coding rate of the LDPC codeword, and a second preset coding rate threshold. The second codeword length is 1296 bits or 162 bytes. The second preset coding rate threshold is less than the reference coding rate of the LDPC codeword, that is, less than 0.5.

Optionally, a value range of the second preset coding rate threshold may be greater than or equal to 0.3 and less than or equal to 0.43.

Optionally, the second length satisfies:

$$L_2 = \left\lceil \frac{N_2 \times (1-R) \times Rth2}{1 - Rth2} \right\rceil_{Int},$$

where

$L_2$ indicates the second length, $N_2$ indicates the second codeword length (equal to 1296 bits or 162 bytes), R indicates the reference coding rate (less than 0.5) of the LDPC codeword, $Rth2$ indicates the second preset coding rate threshold (less than 0.5), and $[x]_{int}$ indicates rounding x.

It may be understood that once the value ranges of the first preset coding rate threshold and the second preset coding rate threshold are determined, value ranges of the first length and the second length are determined.

With reference to the second aspect, in a possible implementation, the first preset coding rate threshold and the second preset coding rate threshold may be the same or may be different.

With reference to the second aspect, in a possible implementation, the determining unit is further configured to perform one or more of the following operations: when the length of the to-be-encoded information bit is greater than the first value and less than or equal to a third length, determining that the length of the LDPC codeword is 1944 bits; when the length of the to-be-encoded information bit is greater than the third length and less than or equal to a fourth length, determining that the length of the LDPC codeword is 1296 bits; or when the length of the to-be-encoded information bit is greater than the fourth length, determining that the length of the LDPC codeword is 1944 bits.

Optionally, the third length is determined based on a third codeword length, the reference coding rate of the LDPC codeword, and a third preset coding rate threshold. The third codeword length is 1944 bits or 243 bytes. The third preset coding rate threshold is less than the reference coding rate of the LDPC codeword. For example, a value range of the third preset coding rate threshold may be greater than 0.4 and less than or equal to 0.5.

For example, the third length satisfies:

$$L_3 = \left\lceil \frac{N_3 \times (1-R) \times Rth3}{1 - Rth3} \right\rceil_{Int},$$

where

$L_3$ indicates the third length, $N_3$ indicates the third codeword length (equal to 1944 bits or 243 bytes), R indicates the reference coding rate (equal to 0.5) of the LDPC codeword, *Rth3* indicates the third preset coding rate threshold (less than 0.5), and [x]*int* indicates rounding x.

Optionally, the fourth length is determined based on the second codeword length and a fourth preset coding rate threshold, and the fourth preset coding rate threshold is less than the reference coding rate of the LDPC codeword. For example, a value range of the fourth preset coding rate threshold may be greater than 0.4 and less than or equal to 0.5.

For example, the fourth length satisfies:

$$L_4 = \left\lceil \frac{N_2 \times Rth4}{1 - Rth4} \right\rceil_{Int},$$

where

$L_4$ indicates the fourth length, $N_2$ indicates the second codeword length (equal to 1296 bits or 162 bytes), *Rth4* indicates the fourth preset coding rate threshold (less than 0.5), and [x]*int* indicates rounding x.

It may be understood that once the value ranges of the third preset coding rate threshold and the fourth preset coding rate threshold are determined, value ranges of the third length and the fourth length are determined.

With reference to the second aspect, in a possible implementation, the third preset coding rate threshold and the fourth preset coding rate threshold may be the same or may be different.

With reference to the second aspect, in a possible implementation, the communication apparatus further includes a transmission unit, configured to transmit the LDPC codeword, where the LDPC codeword includes the to-be-encoded information bit and the parity bit.

With reference to the second aspect, in a possible implementation, a number of shortening zero bits in the LDPC codeword is determined based on the length of the to-be-encoded information bit and a number of information bits in the LDPC codeword. The number of information bits in the LDPC codeword is determined based on the length of the LDPC codeword and the reference coding rate.

For example, the number of shortening zero bits in the LDPC codeword is as follows:

$$Padding\_Num = mod(K - mod(Inf\_Num, K), K),$$

where

Padding_Num indicates the number of shortening zero bits in the LDPC codeword, K indicates the number of information bits in the LDPC codeword, Inf_Num indicates the length of the to-be-encoded information bit, and mod indicates a modulo operation. K=N×R, where N indicates the length of the LDPC codeword, and R indicates the reference coding rate of the LDPC codeword.

With reference to the second aspect, in a possible implementation, the to-be-encoded information bit includes a CRC bit.

According to a third aspect, this application provides a method for determining a length of an LDPC codeword in a UWB system. The method includes: A communication apparatus obtains a length of a to-be-encoded information bit, and determines a length of an LDPC codeword based on the length of the to-be-encoded information bit. A parity-check matrix corresponding to the LDPC codeword is used to encode the to-be-encoded information bit to generate a parity bit. That the communication apparatus determines the length of the LDPC codeword based on the length of the to-be-encoded information bit includes one or more of the following operations: If the length of the to-be-encoded information bit is greater than 648 bits (or 81 bytes) and less than or equal to the third length, the communication apparatus determines that the length of the LDPC codeword is 1944 bits; if the length of the to-be-encoded information bit is greater than the third length and less than or equal to the fourth length, the communication apparatus determines that the length of the LDPC codeword is 1296 bits; or if the length of the to-be-encoded information bit is greater than the fourth length, the communication apparatus determines that the length of the LDPC codeword is 1944 bits. The first value is 648 bits (or 81 bytes). At least one of the third length or the fourth length is determined based on a preset coding rate threshold.

For detailed analysis of beneficial effect of this application, refer to descriptions in the following method embodiments. Details are not described herein. In this application, a higher error control performance gain can be achieved, and a coding rate loss can be reduced.

With reference to the third aspect, in a possible implementation, a reference coding rate of the LDPC codeword is 0.5.

With reference to the third aspect, in a possible implementation, the third length is determined based on a third codeword length, the reference coding rate of the LDPC codeword, and a third preset coding rate threshold. The third codeword length is 1944 bits or 243 bytes. The third preset coding rate threshold is less than the reference coding rate of the LDPC codeword.

Optionally, a value range of the third preset coding rate threshold may be greater than 0.4 and less than or equal to 0.5.

For example, the third length satisfies:

$$L_3 = \left\lceil \frac{N_3 \times (1-R) \times Rth3}{1-Rth3} \right\rceil_{Int},$$

where

$L_3$ indicates the third length, $N_3$ indicates the third codeword length (equal to 1944 bits or 243 bytes), R indicates the reference coding rate (equal to 0.5) of the LDPC codeword, $Rth3$ indicates the third preset coding rate threshold (less than 0.5), and $[x]_{int}$ indicates rounding x.

With reference to the third aspect, in a possible implementation, the fourth length is determined based on a second codeword length and a fourth preset coding rate threshold. The second codeword length is 1296 bits or 162 bytes. The fourth preset coding rate threshold is less than the reference coding rate of the LDPC codeword.

Optionally, a value range of the fourth preset coding rate threshold may be greater than 0.4 and less than or equal to 0.5.

For example, the fourth length satisfies:

$$L_4 = \left\lceil \frac{N_2 \times Rth4}{1-Rth4} \right\rceil_{Int},$$

where

$L_4$ indicates the fourth length, $N_2$ indicates the second codeword length (equal to 1296 bits or 162 bytes), $Rth4$ indicates the fourth preset coding rate threshold (less than 0.5), and $[x]_{int}$ indicates rounding x.

It may be understood that once the value ranges of the third preset coding rate threshold and the fourth preset coding rate threshold are determined, value ranges of the third length and the fourth length are determined.

With reference to the third aspect, in a possible implementation, the third preset coding rate threshold and the fourth preset coding rate threshold may be the same or may be different.

With reference to the third aspect, in a possible implementation, the method further includes: The communication apparatus transmits the LDPC codeword, where the LDPC codeword includes the to-be-encoded information bit and the parity bit. For example, the communication apparatus generates the LDPC codeword based on the determined length of the LDPC codeword, the to-be-encoded information bit, the reference coding rate of the LDPC codeword, and other information, and transmits the LDPC codeword.

With reference to the third aspect, in a possible implementation, a number of shortening zero bits in the LDPC codeword is determined based on the length of the to-be-encoded information bit and a number of information bits in the LDPC codeword. The number of information bits in the LDPC codeword is determined based on the length of the LDPC codeword and the reference coding rate.

For example, the number of shortening zero bits in the LDPC codeword is as follows:

$$\text{Padding\_Num} = \text{mod}(K - \text{mod}(\text{Inf\_Num}, K), K),$$

where

Padding_Num indicates the number of shortening zero bits in the LDPC codeword, K indicates the number of information bits in the LDPC codeword, Inf_Num indicates the length of the to-be-encoded information bit, and mod indicates a modulo operation. $K = N \times R$, where N indicates the length of the LDPC codeword, and R indicates the reference coding rate of the LDPC codeword.

With reference to the third aspect, in a possible implementation, the to-be-encoded information bit includes a CRC bit.

According to a fourth aspect, this application provides a communication apparatus, including an obtaining unit and a determining unit. The obtaining unit is configured to obtain a length of a to-be-encoded information bit. The determining unit is configured to determine a length of a low-density parity-check LDPC codeword based on the length of the to-be-encoded information bit, where a parity-check matrix corresponding to the LDPC codeword is used to encode the to-be-encoded information bit to generate a parity bit. The determining unit is specifically configured to perform one or more operations: when the length of the to-be-encoded information bit is greater than 648 bits (or 81 bytes) and less than or equal to a third length, determining that the length of the LDPC codeword is 1944 bits; when the length of the to-be-encoded information bit is greater than the third length and less than or equal to a fourth length, determining that the length of the LDPC codeword is 1296 bits; or when the length of the to-be-encoded information bit is greater than the fourth length, determining that the length of the LDPC codeword is 1944 bits.

With reference to the fourth aspect, in a possible implementation, a reference coding rate of the LDPC codeword is 1/2.

With reference to the fourth aspect, in a possible implementation, the third length is determined based on a third codeword length, the reference coding rate of the LDPC codeword, and a third preset coding rate threshold. The third codeword length is 1944 bits or 243 bytes. The third preset coding rate threshold is less than the reference coding rate of the LDPC codeword.

Optionally, a value range of the third preset coding rate threshold may be greater than 0.4 and less than or equal to 0.5.

For example, the third length satisfies:

$$L_3 = \left\lceil \frac{N_3 \times (1-R) \times Rth3}{1-Rth3} \right\rceil_{Int},$$

where

$L_3$ indicates the third length, $N_3$ indicates the third codeword length (equal to 1944 bits or 243 bytes), R indicates the reference coding rate (equal to 0.5) of the LDPC codeword, $Rth3$ indicates the third preset coding rate threshold (less than 0.5), and $[x]_{int}$ indicates rounding x.

With reference to the fourth aspect, in a possible implementation, the fourth length is determined based on a second codeword length and a fourth preset coding rate threshold. The second codeword length is 1296 bits or 162 bytes. The fourth preset coding rate threshold is less than the reference coding rate of the LDPC codeword.

Optionally, a value range of the fourth preset coding rate threshold may be greater than 0.4 and less than or equal to 0.5.

For example, the fourth length satisfies:

$$L_4 = \left\lceil \frac{N_2 \times Rth4}{1-Rth4} \right\rceil_{Int},$$

where

$L_4$ indicates the fourth length, $N_2$ indicates the second codeword length (equal to 1296 bits or 162 bytes), $Rth4$ indicates the fourth preset coding rate threshold (less than 0.5), and $[x]_{int}$ indicates rounding x.

It may be understood that once the value ranges of the third preset coding rate threshold and the fourth preset coding rate threshold are determined, value ranges of the third length and the fourth length are determined.

With reference to the fourth aspect, in a possible implementation, the third preset coding rate threshold and the fourth preset coding rate threshold may be the same or may be different.

With reference to the fourth aspect, in a possible implementation, the communication apparatus further includes a transmission unit, configured to transmit the LDPC codeword, where the LDPC codeword includes the to-be-encoded information bit and the parity bit.

With reference to the fourth aspect, in a possible implementation, a number of shortening zero bits in the LDPC codeword is determined based on the length of the to-be-encoded information bit and a number of information bits in the LDPC codeword. The number of information bits in the LDPC codeword is determined based on the length of the LDPC codeword and the reference coding rate.

For example, the number of shortening zero bits in the LDPC codeword is as follows:

$$Padding\_Num = mod(K - mod(Inf\_Num, K), K),$$

where

Padding_Num indicates the number of shortening zero bits in the LDPC codeword, K indicates the number of information bits in the LDPC codeword, Inf_Num indicates the length of the to-be-encoded information bit, and mod indicates a modulo operation. $K = N \times R$, where N indicates the length of the LDPC codeword, and R indicates the reference coding rate of the LDPC codeword.

With reference to the fourth aspect, in a possible implementation, the to-be-encoded information bit includes a CRC bit.

According to a fifth aspect, this application provides a communication apparatus. The communication apparatus includes a processor, configured to perform the method according to the first aspect or the third aspect, or any possible implementation of the first aspect or the third aspect is performed. Alternatively, the processor is configured to execute a program stored in a memory, and when the program is executed, the method according to the first aspect or the third aspect, or any possible implementation of the first aspect or the third aspect is performed.

With reference to the fifth aspect, in a possible implementation, the memory is located outside the communication apparatus.

With reference to the fifth aspect, in a possible implementation, the memory is located inside the communication apparatus.

In this embodiment of this application, the processor and the memory may alternatively be integrated into one device, that is, the processor and the memory may alternatively be integrated together.

With reference to the fifth aspect, in a possible implementation, the communication apparatus further includes a transceiver. The transceiver is configured to receive a signal or send a signal.

According to a sixth aspect, this application provides a communication apparatus. The communication apparatus includes a logic circuit and an interface, and the logic circuit is coupled to the interface.

In a design, the logic circuit is configured to: obtain a length of a to-be-encoded information bit, and determine a length of a low-density parity-check LDPC codeword based on the length of the to-be-encoded information bit, where a parity-check matrix corresponding to the LDPC codeword is used to encode the to-be-encoded information bit to generate a parity bit. The interface is configured to output the LDPC codeword, where the LDPC codeword includes the to-be-encoded information bit and the parity bit. The length of the to-be-encoded information bit and the length of the LDPC codeword meet one or more of the following conditions: If the length of the to-be-encoded information bit is greater than 0 and less than or equal to a first length, the length of the LDPC codeword is 648 bits; if the length of the to-be-encoded information bit is greater than the first length and less than or equal to a second length, the length of the LDPC codeword is 1296 bits; or if the length of the to-be-encoded information bit is greater than the second length and less than or equal to a first value, the length of the LDPC codeword is 1944 bits. At least one of the first length or the second length is determined based on a preset coding rate threshold.

In another design, the logic circuit is configured to: obtain a length of a to-be-encoded information bit, and determine a length of a low-density parity-check LDPC codeword based on the length of the to-be-encoded information bit, where a parity-check matrix corresponding to the LDPC codeword is used to encode the to-be-encoded information bit to generate a parity bit. The interface is configured to output the LDPC codeword, where the LDPC codeword includes the to-be-encoded information bit and the parity bit. The length of the to-be-encoded information bit and the length of the LDPC codeword meet one or more of the following conditions: If the length of the to-be-encoded information bit is greater than the first value and less than or equal to a third length, the length of the LDPC codeword is 1944 bits; if the length of the to-be-encoded information bit is greater than the third length and less than or equal to a fourth length, the length of the LDPC codeword is 1296 bits; or if the length of the to-be-encoded information bit is greater than the fourth length, the length of the LDPC codeword is 1944 bits, where the first value is 648 bits or 81 bytes. At least one of the third length or the fourth length is determined based on a preset coding rate threshold.

According to a seventh aspect, this application provides a computer-readable storage medium. The computer-readable storage medium is configured to store a computer program. When the computer program is run on a computer, the method according to the first aspect or the third aspect, or any possible implementation of the first aspect or the third aspect is performed.

According to an eighth aspect, this application provides a computer program product. The computer program product includes a computer program or computer code. When the computer program product runs on a computer, the method according to the first aspect or the third aspect, or any possible implementation of the first aspect or the third aspect is performed.

According to a ninth aspect, this application provides a computer program. When the computer program is run on a computer, the method according to the first aspect or the third aspect, or any possible implementation of the first aspect or the third aspect is performed.

For technical effect achieved in the foregoing aspects, refer to each other or technical effect in the following method embodiments. Details are not described herein.

**BRIEF DESCRIPTION OF DRAWINGS**

To describe technical solutions in embodiments of this application more clearly, the following briefly describes accompanying drawings for describing embodiments.

FIG. 1 is a diagram of a structure of a wireless communication system according to an embodiment of this application;

FIG. 2 is a diagram of another structure of a wireless communication system according to an embodiment of this application;

FIG. 3a is a diagram of an LDPC code parity-check matrix according to an embodiment of this application;

FIG. 3b is a Tanner graph of an LDPC code according to an embodiment of this application;

FIG. 4a is a diagram of an LDPC code parity-check matrix with a coding rate of 1/2 and a code length of 648 according to an embodiment of this application;

FIG. 4b is a diagram of a cyclic shift matrix P1 according to an embodiment of this application;

FIG. 5 is a diagram of an LDPC encoding process in a WLAN according to an embodiment of this application;

FIG. 6a is a diagram of an LDPC code parity-check matrix with a coding rate of 1/2 and a code length of 1296 according to an embodiment of this application;

FIG. 6b is a diagram of an LDPC code parity-check matrix with a coding rate of 1/2 and a code length of 1944 according to an embodiment of this application;

FIG. 7 is a schematic flowchart of a method for determining a length of an LDPC codeword in a UWB system according to an embodiment of this application;

FIG. 8 is a diagram of an LDPC encoding process in a UWB system according to an embodiment of this application;

FIG. 9 is a diagram of numbers of shortening zero bits required by LDPC codes with different code lengths varying with a length of a to-be-encoded information bit according to an embodiment of this application;

FIG. 10 is a diagram of effective coding rates of LDPC codes with different code lengths varying with a length of a to-be-encoded information bit according to an embodiment of this application;

FIG. 11a is a diagram of selecting a length of an LDPC codeword according to an embodiment of this application;

FIG. 11b is another diagram of selecting a length of an LDPC codeword according to an embodiment of this application;

FIG. 11c is still another diagram of selecting a length of an LDPC codeword according to an embodiment of this application;

FIG. 12 is yet another diagram of selecting a length of an LDPC codeword according to an embodiment of this application;

FIG. 13 is another schematic flowchart of a method for determining a length of an LDPC codeword in a UWB system according to an embodiment of this application;

FIG. 14 is still yet another diagram of selecting a length of an LDPC codeword according to an embodiment of this application;

FIG. 15 is a diagram of a structure of a communication apparatus according to an embodiment of this application;

FIG. 16 is a diagram of a structure of a communication apparatus 1000 according to an embodiment of this application; and

FIG. 17 is a diagram of another structure of a communication apparatus according to an embodiment of this application.

## DESCRIPTION OF EMBODIMENTS

The following clearly and completely describes the technical solutions in embodiments of this application with reference to the accompanying drawings in embodiments of this application.

In descriptions of this application, unless otherwise specified, "/" means "or". For example, A/B may indicate A or B. A term "and/or" in this specification describes only an association relationship between associated objects and indicates that there may be three relationships. For example, A and/or B may represent the following three cases: Only A exists, both A and B exist, and only B exists. In addition, "at least one" means one or more, and "a plurality of" means two or more. At least one of the following items (pieces) or a similar expression thereof indicates any combination of these items, including a single item (piece) or any combination of a plurality of items (pieces). For example, at least one of a, b, or c may represent a, b, c, a and b, a and c, b and c, or a, b, and c, where a, b, and c each may be singular or plural.

In addition, the terms "include", "have", and any variants thereof are intended to cover a non-exclusive inclusion. For example, processes, methods, systems, products, or devices that include a series of steps or units are not limited to listed steps or units, but optionally further include steps or units that are not listed, or optionally further include other steps or units inherent to these processes, methods, products, or devices.

In this application, the term "example" or "for example" is used to represent giving an example, an illustration, or a description. Any embodiment or design scheme described as "example", "such as" or "for example" in this application should not be explained as being more preferred or having more advantages than another embodiment or design scheme. Exactly, use of the word "example", "such as", "for example", or the like is intended to present a related concept in a specific manner.

It should be understood that, in this application, "when" and "if" mean that an apparatus performs corresponding processing in an objective situation, and are not intended to limit time. The terms do not mean that the apparatus is required to have a determining action during implementation, and do not mean any other limitation.

In this application, unless otherwise specified, an element represented in a singular form is intended to represent "one or more", but is not intended to represent "only one".

It should be understood that, in embodiments of this application, determining B based on A does not mean that B is determined only based on A, and B may alternatively be determined based on A and/or other information.

Technical solutions provided in this application are applicable to a wireless personal area network (wireless personal area network, WPAN) based on a UWB technology. For example, a method provided in this application is applicable to an IEEE 802.15 series protocol, for example, an 802.15.4ab protocol or a future generation of UWB WPAN standard. Examples are not listed one by one herein. The method provided in this application may be further applied to various communication systems, such as an internet of things (internet of things, IoT) system, vehicle-to-everything (vehicle to X, V2X), and a narrowband internet of things (narrowband internet of things, NB-IoT) system, or is applied to a device in vehicle-to-everything, an internet of things node, a sensor, or the like in the internet of things (IoT, internet of things), a smart camera, a smart remote control, and a smart water or electricity meter in a smart home, a sensor in a smart city, and the like. The method provided in this application is further applicable to an LTE frequency division duplex (frequency division duplex, FDD) system, an LTE time division duplex (time division duplex, TDD) system, a universal mobile telecommunications system (universal mobile telecommunications system, UMTS), a worldwide interoperability for microwave access (worldwide interoperability for microwave access, WiMAX) communication system, a long term evolution (long term evolution, LTE) system, a 5th-generation (5th-generation, 5G) communication system, a 6th-generation (6th-generation, 6G) communication system, and the like.

The UWB technology is a new wireless communication technology. In the UWB technology, data is transmitted through a nanosecond-level non-sinusoidal narrow pulse, and modulation is performed on impulses with very steep rise and fall time, and therefore, the UWB technology occupies a wide spectrum range, so that a signal has a bandwidth of a Giga Hertz (GHz) magnitude. A bandwidth used by UWB is usually higher than 1 GHz. A UWB system does not need to generate a sinusoidal carrier signal and can directly transmit an impulse sequence. Therefore, the UWB system has a wide spectrum and low average power. A UWB wireless communication system has advantages such as a strong multi-path resolution capability, low power consumption, and high confidentiality. This facilitates coexistence with other systems, thereby improving spectrum utilization and system capacity. In addition, in a short-range communication application, transmit power of a UWB transmitter may be usually lower than 1 mW (milliwatt). Theoretically, interference generated by a UWB signal is only equivalent to white noise. This facilitates good coexistence between ultra-wideband and existing narrowband communication. Therefore, the UWB system and a narrowband (narrowband, NB) communication system can simultaneously operate without interfering with each other. The method provided in this application may be implemented by a communication apparatus in a wireless communication system. In a communication apparatus, an apparatus or a chip for implementing a function of the UWB system may be referred to as a UWB module, and an apparatus or a chip for implementing a function of the narrowband communication system may be referred to as a narrowband communication module. The UWB module and the narrowband communication module may be different apparatuses or chips. Certainly, the UWB module and the narrowband communication module may alternatively be integrated into one apparatus or chip. Implementations of the UWB module and the narrowband communication module in the communication apparatus are not limited in embodiments of this application. A communication apparatus in this application includes a UWB module, and optionally, further includes a narrowband communication module.

The method provided in this application may be implemented by a communication apparatus in a wireless communication system. The communication apparatus may be an apparatus in a UWB system. For example, the communication apparatus may include but is not limited to a communication server, a router, a switch, a bridge, a computer, a mobile phone, and the like that support the UWB technology. For another example, the communication apparatus may include user equipment (user equipment, UE). The user equipment may include various devices that support the UWB technology, such as a handheld device, a vehicle-mounted device (for example, a vehicle or a component mounted in a vehicle), a wearable device, an internet of things (internet of things, IoT) device, a computing device, or another processing device connected to a wireless modem. Examples are not listed one by one herein. For still another example, the communication apparatus may include a central control point, for example, a personal area network (personal area network, PAN) or a PAN coordinator. The PAN coordinator or the PAN may be a mobile phone, a vehicle-mounted device, an anchor (Anchor), a tag (tag), a smart home, or the like. For yet another example, the communication apparatus may include a chip, and the chip may be disposed in a communication server, a router, a switch, a terminal device, or the like. Examples are not enumerated herein. It can be understood that the foregoing descriptions about the communication apparatus are applicable to the communication apparatus in this application.

Optionally, the communication apparatus in embodiments of this application may be a device that supports a plurality of WPAN standards, such as IEEE 802.15.4ab that is currently being discussed or a later version.

In embodiments of this application, the communication apparatus may include a hardware layer, an operating system layer running above the hardware layer, and an application layer running above the operating system layer. The hardware layer includes hardware such as a central processing unit (central processing unit, CPU), a memory management unit (memory management unit, MMU), and a memory (also referred to as a main memory). The operating system may be any one or more types of computer operating systems that implement service processing through a process (process), for example, a Linux operating system, a Unix operating system, an Android operating system, an iOS operating system, or a Windows operating system. The application layer includes applications such as a browser, an address book, word processing software, and instant messaging software. In addition, a specific structure of an execution body of the method provided in embodiments of this application is not specifically limited in embodiments of this application, provided that communication can be performed according to the method provided in embodiments of this application by running a program that records code of the method provided in embodiments of this application.

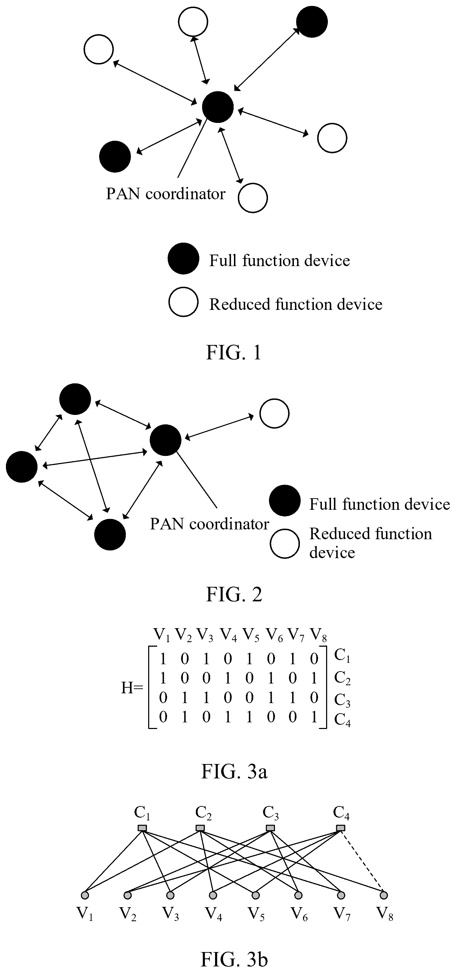

For example, FIG. 1 is a diagram of a structure of a wireless communication system according to an embodiment of this application. As shown in FIG. 1, the wireless communication system is a star topology structure. In this structure, a central control node (for example, a PAN coordinator in FIG. 1) may perform data communication with one or more other devices. FIG. 2 is a diagram of another structure of a wireless communication system according to an embodiment of this application. As shown in FIG. 2, the wireless communication system is of a peer-to-peer topology structure. In this structure, a central control node (for example, a PAN coordinator in FIG. 2) may perform data communication with one or more other devices, and other different devices may also perform data communication with each other. In FIG. 1 and FIG. 2, both a full function device (full function device) and a reduced function device (reduced function device) may be understood as communication apparatuses shown in this application. The full function device is relative to the reduced function device. For example, the reduced function device cannot be a PAN coordinator (coordinator). For another example, compared with the full function device, the reduced function device may have no coordination capability or have a lower communication rate than the full function device. It may be understood that the PAN coordinator shown in FIG. 2 is merely an example, and each of the other three full function devices shown in FIG. 2 may also be used as a PAN coordinator. Examples are not shown one by one herein. It can be further understood that the full function device and the reduced function device shown in this application are merely example communication apparatuses. Any apparatus capable of implementing a method for determining a length of an LDPC codeword in a UWB system in this application falls within the protection scope of this application.

The following briefly describes some related content, terms, or nouns in this application.

1. LDPC code

An LDPC code parity-check matrix is a sparse matrix. To be specific, a number of non-zero elements in the matrix is far less than a number of zero elements, or a ratio of a row weight to a code length in the matrix and a ratio of a column weight to the code length in the matrix are both quite small values. An LDPC code may be expressed in a graph, and the graph is referred to as a Tanner graph. The Tanner graph is in a one-to-one correspondence with the parity-check matrix, and includes two types of nodes: A first type of node indicates a codeword symbol, and is referred to as a variable node. A second type of node indicates a check constraint relationship, and is referred to as a check node. Each check node indicates one check constraint relationship. For example, as shown in FIG. 3a and FIG. 3b, FIG. 3a is a diagram of an LDPC code parity-check matrix according to an embodiment of this application, and FIG. 3b is a Tanner graph of an LDPC code according to an embodiment of this application. In FIG. 3a and FIG. 3b, $\{V_i\}$ indicates a variable node set, and $\{C_i\}$ indicates a check node set.

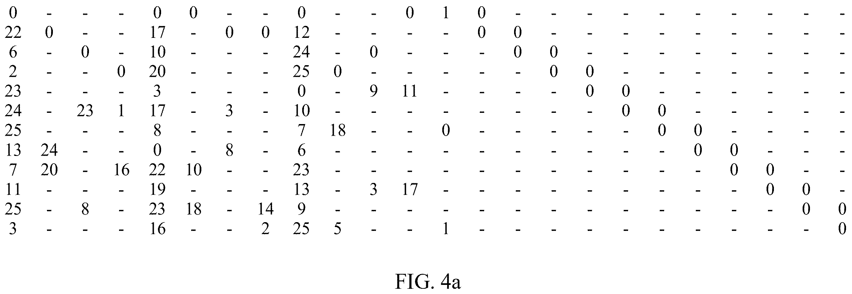

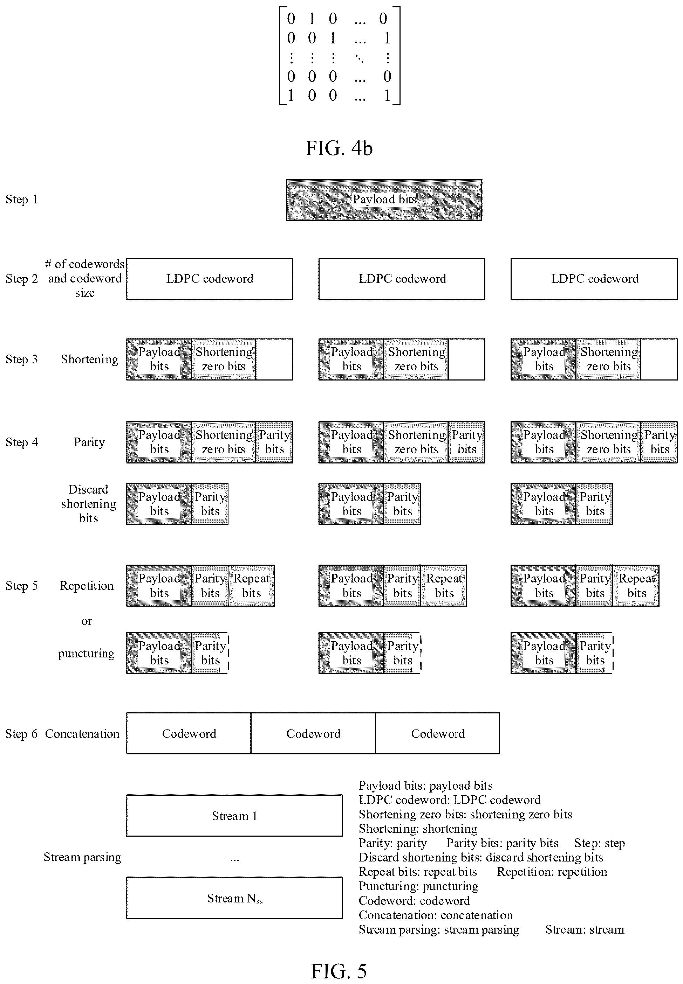

An LDPC code used in the 802.11ac/ax standards is a quasi cyclic LDPC (quasi cyclic LDPC, QC-LDPC) code. The QC-LDPC code is a structured LDPC code that is widely used. A parity-check matrix of the QC-LDPC code has a unique structure, and encoding may be implemented by using a simple feedback shift register. Therefore, a problem of encoding complexity of the LDPC code can be well resolved. FIG. 4a is a diagram of an LDPC code parity-check matrix with a coding rate of 1/2 and a code length of 648 according to an embodiment of this application. As shown in FIG. 4a, each element in the LDPC code parity-check matrix with a code length N of 648 and a coding rate R of 1/2 indicates a Z-order matrix, where Z=N/24, "0" indicates a $Z \times Z$ unit matrix, and "-" indicates a $Z \times Z$ all-zero matrix. For example, an element "22" in FIG. 4a indicates that a $Z \times Z$ unit matrix P is cyclically shifted rightward by 22 bits to obtain a cyclic shift matrix $P_{22}$. Other non-zero elements in FIG. 4a are similar to the element "22". Details are not described again. $P_i$ indicates a cyclic shift matrix, and i ($0 \leq i \leq Z-1$) indicates a cyclic shift value. FIG. 4b is a diagram of a cyclic shift matrix $P_1$ according to an embodiment of this application. As shown in FIG. 4b, the cyclic shift matrix $P_1$ indicates that a $Z \times Z$ unit matrix P is cyclically shifted rightward by one bit.

In an existing WLAN standard (for example, 802.11n/ac), an orthogonal frequency division multiplexing (orthogonal frequency division multiplexing, OFDM) technology is used. An LDPC encoding module needs to encode data bits (which may also be understood as payload bits (payload bits)), and then place encoded bits into an integer number of OFDM symbols. The encoded bits also need to be able to be exactly placed into an integer number of LDPC codewords. Therefore, before transmission, a minimum number $N_{SYM}$ of OFDM symbols required for current transmission needs to be computed. Then, a total number of encoded bits that can be stored in all the OFDM symbols is computed based on the $N_{SYM}$ and a current modulation and coding scheme: $N_{TCB}=N_{CBPS}\times N_{SYM}$, where $N_{CBPS}$ indicates a number of encoded bits that can be stored in each OFDM symbol. Then, an LDPC code length $L_{LDPC}$ used in current transmission and a number $N_{CW}$ of required codewords are determined based on the total number of encoded bits $N_{TCB}$. However, for most lengths of to-be-encoded data bits and modulation and coding schemes, there are not sufficient data bits to fill information bit positions in an LDPC codeword. Therefore, a shortening (shorten) operation needs to be performed before a parity bit (parity bit) is generated. The shortening (shorten) operation means inserting a specific number of 0s into the information bit positions in the LDPC codeword before the parity bit is generated through LDPC encoding. The 0s are deleted after the parity bit is generated through LDPC encoding. FIG. 5 is a diagram of an LDPC encoding process in a WLAN according to an embodiment of this application. As shown in FIG. 5, the LDPC encoding process in the WLAN includes at least step 1 (step 1) to step 6 (step 6). Specifically, step 1 includes to-be-encoded data bits, for example, payload bits (payload bits). Step 2: Determine a length $L_{LDPC}$ of an LDPC codeword and a number $N_{CW}$ of codewords. For a specific determining method, refer to the following descriptions. Step 3: Perform a shortening operation on the to-be-encoded data bits, to be specific, fill in shortening zero bits (shortening zero bits) after the to-be-encoded data bits. Step 4: Encode to-be-encoded data bits and shortening zero bits in each LDPC codeword by using an LDPC code parity-check matrix to generate parity bits, and then delete the shortening zero bits. Step 5: Repeat (repeat) some to-be-encoded data bits in the LDPC codeword, or puncture (puncture) the parity bits in the LDPC codeword, so that processed (punctured or repeated) codeword bits exactly fill a to-be-transmitted OFDM symbol. To be specific, a number of processed (punctured or repeated) codeword bits is equal to a number of bits that can be carried in the OFDM symbol. Step 6: Concatenate (concatenation) a plurality of codewords, and perform stream parsing (stream parsing).

In this application, an "LDPC code length" is an LDPC codeword length (LDPC codeword length), and the "LDPC code length", a "length of an LDPC codeword", and the "LDPC codeword length" may be used interchangeably.

2. Method for determining a length of an LDPC codeword in the 802.11ac/ax standards

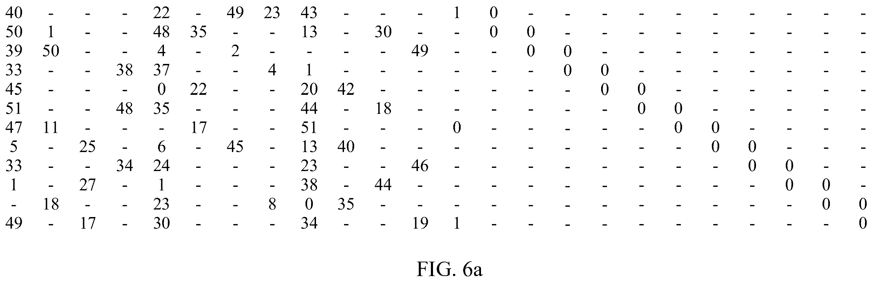

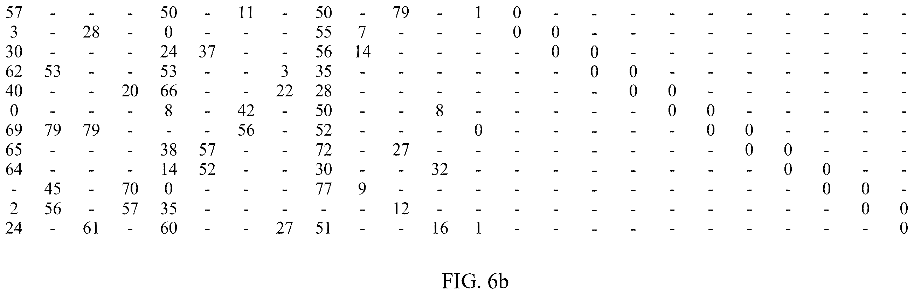

In the 802.11ac/ax standards, a total of 12 LDPC code parity-check matrices are used, and three code lengths are included: 648 bits, 1296 bits, and 1944 bits. Each code length supports four different coding rates (where the coding rates herein are reference coding rates): 1/2, 2/3, 3/4, and 5/6. FIG. 6a and FIG. 6b show an LDPC code parity-check matrix with a coding rate of 1/2 (namely, R=1/2) and a code length of 1296 bits and an LDPC code parity-check matrix with a coding rate of 1/2 and a code length of 1944 bits respectively. An LDPC code parity-check matrix with a coding rate of 1/2 and a code length of 648 bits is shown in FIG. 4a. It should be understood that, for meanings of elements in FIG. 6a and FIG. 6b, refer to the meanings of the elements in FIG. 4a. Details are not described herein again.

Optionally, selection of a coding rate in the 802.11ac/ax standards is determined by a modulation and coding scheme (modulation and coding scheme, MCS) adaptively selected by a link. In a WLAN, an LDPC code is selected from the 12 parity-check matrices based on a code length and a coding rate, and different code lengths and coding rates correspond to different parity-check matrices. For a given coding rate, in an existing WLAN standard, an LDPC code length required for current data transmission is computed jointly based on a current data packet length and a current number of OFDM symbols.

Specifically, manners of computing an LDPC codeword length in existing WLAN standards are as follows.

1. Compute a number of OFDM symbols required for current data transmission:

$$N_{SYM}=m_{STBC}\cdot\left\lceil\frac{8\cdot length+16}{m_{STBC}\cdot N_{DBPS}}\right\rceil \quad\text{-------------------------------------------}(1\text{-}1)$$

$N_{SYM}$ indicates the number of OFDM symbols required for current data transmission, *length* indicates a length (in a unit of byte (Byte)) of a data packet, $m_{STBC}$ indicates a space-time block coding mode of the data packet (where a value is 1 when space-time block coding is not used), $N_{DBPS}$ indicates a number of data bits carried in each OFDM symbol, and $\lceil \ \rceil$ indicates rounding up. Details are not described below again.

2. Compute a bit length obtained by adding 16 cyclic redundancy check (cyclic redundancy check, CRC) bits to current data transmission:

$$N_{pld}=8\cdot length+16 \quad\text{-----------------------------------------------------}(1\text{-}2)$$

3. Compute a number of codeword bits in current data transmission:

$$N_{TCB}=N_{CBPS}\times N_{SYM} \quad\text{-------------------------------------------------}(1\text{-}3)$$

$N_{TCB}$ indicates a number of codeword bits in current data transmission, and $N_{CBPS}$ indicates a number of codeword bits carried by each OFDM symbol.

4. Determine an LDPC codeword length for current data transmission based on the foregoing parameters ($N_{TCB}$, $N_{pld}$, and the like) and the following Table 1.

Table 1

| Range of $N_{TCB}$ (range (bits) of $N_{TCB}$) | Number of LDPC codewords (number of LDPC codewords ($Ncw$)) | LDPC codeword length (LDPC codeword length in bits ($L_{LDPC}$)) |
|---|---|---|
| $N_{TCS} \leq 648$ | 1 | 1296, if $N_{TCB} \geq N_{pld} + 912 \times (1\text{-}R)$ 648, otherwise |
| $648 < N_{TCB} \leq 1296$ | 1 | 1944, if $N_{TCB} \geq N_{pld} + 1464 \times (1\text{-}R)$ 1296, otherwise |
| $1296 < N_{TCS} \leq 1944$ | 1 | 1944 |
| $1944 < N_{TCB} \leq 2592$ | 2 | 1944, if $N_{TCB} \geq N_{pld} + 2916 \times (1\text{-}R)$ 1296, otherwise |
| $2592 < N_{TCB}$ | $\left\lceil \dfrac{N_{pld}}{1944 \cdot R} \right\rceil$ | 1944 |

It should be understood that R in Table 1 indicates a coding rate.

In a WLAN standard, in addition to the foregoing parameters ($N_{TCB}$, $N_{pld}$, and the like), performance of a long code and a number of punctured bits need to be comprehensively considered for selecting an LDPC codeword length. As shown in step 5 in FIG. 5, in the WLAN, a puncturing operation may need to be performed after LDPC encoding. To be specific, several parity bits at the end are not transmitted. However, puncturing causes an increase in an actual coding rate (to be specific, an actual coding rate is greater than a reference coding rate), leading to a performance loss to some extent. A longer LDPC code length has better error control performance. Therefore, a long code should be selected during code length selection to the greatest extent. However, in practice, a code length of an LDPC code in the WLAN needs to be selected based on a tradeoff between a long code and a number of punctured bits. As shown in Table 1, a code length to be selected for an LDPC code in the WLAN does not monotonically increase with an increase in a data packet length, but may continuously decrease to a shorter code length with an increase in a data packet length. In addition, because encoded bits need to fill at least a single OFDM symbol, when a shortest packet length (to be specific, $N_{TCB} \leq 648$) is used, a medium code length (1296 bits), instead of a shortest code length (648 bits), is selected for an LDPC code in the WLAN.

It can be learned from the foregoing content that, to improve transmission reliability of a wireless transmission system, the LDPC code is widely used in WLAN standards. In a next-generation UWB standard like the IEEE 802.15ab standard, an LDPC code with a coding rate of 1/2 in the WLAN is to be introduced to improve transmission reliability of a system. An important candidate solution is to reuse LDPC codes, in the WLAN, whose coding rates are 1/2 and whose code lengths are 648 bits, 1296 bits, and 1944 bits. However, if the LDPC codes, in the WLAN, whose coding rates are 1/2 and whose code lengths are 648 bits, 1296 bits, and 1944 bits are reused, how to determine a length of an LDPC codeword in a UWB system urgently needs to be studied.

This application provides a method for determining a length of an LDPC codeword in a UWB system and a related apparatus, to ensure that a long code is used as much as possible in UWB transmission to achieve a higher error control performance gain, and reduce a coding rate loss caused by excessive shortening zero bits. Further, in this application, it can be further ensured that an effective coding rate of a short packet is less than a given threshold, to improve short packet performance.

The following describes in detail the technical solutions provided in this application with reference to more accompanying drawings.

To clearly describe the technical solutions of this application, this application is described by using a plurality of embodiments. For details, refer to the following descriptions. In this application, unless otherwise specified, for same or similar parts of embodiments or implementations, refer to each other. In embodiments of this application and the implementations/implementation methods in embodiments, unless otherwise specified or a logical conflict occurs, terms and/or descriptions are consistent and may be mutually referenced between different embodiments and between the implementations/implementation methods in embodiments. Technical features in the different embodiments and the implementations/implementation methods in embodiments may be combined to form a new embodiment, implementation, or implementation method based on an internal logical relationship thereof. The following implementations of this application are not intended to limit the protection scope of this application. It should be understood that a sequence of the following embodiments does not represent a degree of importance.

Embodiment 1

Embodiment 1 of this application mainly describes a method for determining a length of an LDPC codeword when a length of a to-be-encoded information bit is less than or equal to 648 bits (or 81 bytes).

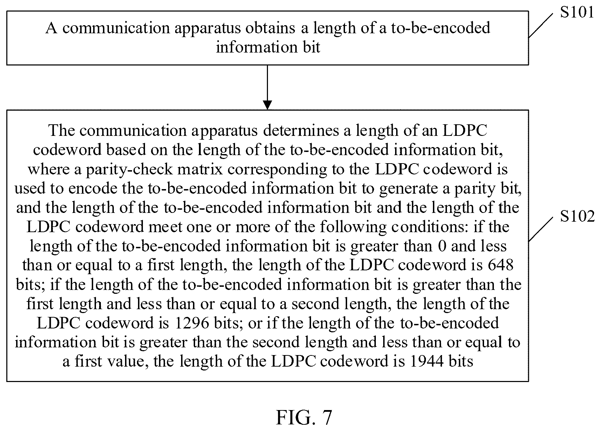

FIG. 7 is a schematic flowchart of a method for determining a length of an LDPC codeword in a UWB system according to an embodiment of this application. A communication apparatus in the method may be any device in FIG. 1 or FIG. 2. As shown in FIG. 7, the method for determining a length of an LDPC codeword in a UWB system includes but is not limited to the following steps.

S101: The communication apparatus obtains a length of a to-be-encoded information bit.

In this embodiment of this application, the to-be-encoded information bit may be an information bit that has not undergone channel coding, namely, an information bit input to an input end of a channel coding module. For example, the to-be-encoded information bit may be a to-be-encoded data bit (namely, a payload bit), or the to-be-encoded information bit includes a to-be-encoded data bit and a CRC bit. This is not limited in embodiments of this application.

S102: The communication apparatus determines a length of an LDPC codeword based on the length of the to-be-encoded information bit, where a parity-check matrix corresponding to the LDPC codeword is used to encode the to-be-encoded information bit to generate a parity bit. The length of the to-be-encoded information bit and the length of the LDPC codeword meet one or more of the following conditions: if the length of the to-be-encoded information bit is greater than 0 and less than or equal to a first length, the length of the LDPC codeword is 648 bits; if the length of the to-be-encoded information bit is greater than the first length and less than or equal to a second length, the length of the LDPC codeword is 1296 bits; or if the length of the to-be-encoded information bit is greater than the second length and less than or equal to a first value, the length of the LDPC codeword is 1944 bits.

A reference coding rate R of the LDPC codeword is 1/2. The first value may be 648 bits or 81 bytes.

Optionally, the first length and the second length may be indicated by using a number of bits (bits), or may be indicated by using a number of bytes (bytes). This is not limited in embodiments of this application. The first length may be determined based on a first codeword length, the reference coding rate R of the LDPC codeword, and a first preset coding rate threshold. The second length may be determined based on a second codeword length, the reference coding rate R of the LDPC codeword, and a second preset coding rate threshold. The first codeword length is 648 bits or 81 bytes, and the second codeword length is 1296 bits or 162 bytes. The first preset coding rate threshold and the second preset coding rate threshold may be the same or may be different. Both the first preset coding rate threshold and the second preset coding rate threshold are less than or equal to the reference coding rate R (namely, 0.5).

For example, the first length satisfies the following formula (2-1):

$$L_1 = \left\lceil \frac{N_1 \times (1\text{-}R) \times Rth1}{1 - Rth1} \right\rceil_{Int} \text{...............................................}(2\text{-}1)$$

$L_1$ indicates the first length. A same expression in the following has a same meaning. Details are not described again. $N_1$ indicates the first codeword length, and is equal to 648 bits or 81 bytes. R indicates the reference coding rate, and is equal to 1/2. $Rth1$ indicates the first preset coding rate threshold, and is less than or equal to 1/2. $[x]_{Int}$ indicates rounding x. Rounding in embodiments of this application may be rounding up or rounding down. This is not limited in embodiments of this application. A same symbol in the following has a same meaning. Details are not described again.

For example, the second length satisfies the following formula (2-2):

$$L_2 = \left\lceil \frac{N_2 \times (1 - R) \times Rth2}{1 - Rth2} \right\rceil_{Int} \text{...............................................}(2\text{-}2)$$

$L_2$ indicates the second length. A same expression in the following has a same meaning. Details are not described again. $N_2$ indicates the second codeword length, and is equal to 1296 bits or 162 bytes. $Rth2$ indicates the second preset coding rate threshold, and is less than or equal to 1/2.

It may be understood that, if the first codeword length is in a unit of bit, for example, 648 bits, the first length may also be indicated by using a number of bits. Certainly, the first length may alternatively be indicated by using a number of bytes (where 8 bits=1 byte). For example, a result (in a unit of bit) computed by using the foregoing formula (2-1) is converted into a byte size (if the byte size obtained through the conversion is not an integer, a rounding operation can be performed). If the first codeword length is in a unit of byte, for example, 81 bytes, the first length may also be indicated by using a number of bytes. Certainly, the first length may alternatively be indicated by using a number of bits. Details are not described herein again. Similarly, if the second codeword length is in a unit of bit, for example, 1296 bits, the second length may also be indicated by a number of bits (where 1 byte=8 bits). Certainly, the second length may alternatively be indicated by a number of bytes, for example, a result (in a unit of bit) computed by using the foregoing formula (2-2) is converted into a byte size (if the byte size obtained through the conversion is not an integer, a rounding operation can be performed). If the second codeword length is in a unit of byte, for example, 162 bytes, the second length may also be indicated by using a number of bytes. Certainly, the second length may alternatively be indicated by using a number of bits. Details are not described herein again.

Optionally, value ranges of the first preset coding rate threshold $Rth1$ and the second preset coding rate threshold $Rth2$ may be both greater than or equal to 0.3 and less than or equal to 0.43. Alternatively, a value range of the first preset coding rate threshold $Rth1$ may be a subset in a range that is greater than or equal to 0.3 and less than or equal to 0.43, and a value range of the second preset coding rate threshold $Rth2$ may be a subset in a range that is greater than or equal to 0.3 and less than or equal to 0.43. It may be understood that the value ranges of the first preset coding rate threshold $Rth1$ and the second preset coding rate threshold $Rth2$ are merely examples. The first preset coding rate threshold $Rth1$ near 0.3, for example, 0.29 or 0.28, or near 0.43, for example, 0.45 or 0.44, also falls within the protection scope of this application. Similarly, the second preset coding rate threshold $Rth2$ near 0.3, for example, 0.29 or 0.28, or near 0.43, for example, 0.45 or 0.44, also falls within the protection scope of this application.

It may be understood that once the value ranges of the first preset coding rate threshold $Rth1$ and the second preset coding rate threshold $Rth2$ are determined, and value ranges of the first length and the second length are determined according to the foregoing formula (2-1) and the foregoing formula (2-2). Examples are not listed one by one herein. For example, the first length is indicated by using bits. When the value range of the first preset coding rate threshold $Rth1$ is greater than 0.3 and less than 0.43, it may be determined, according to the foregoing formula (2-1), that the value range of the first length is greater than 138 bits (rounded down) and less than 244 bits (rounded down), or greater than 139 bits (rounded up) and less than 245 bits (rounded up), or greater than 138 bits and less than 245 bits, or greater than 139 bits and less than 244 bits, or the like. Similarly, for example, the second length is indicated by using bits. When the value range of the second preset coding rate threshold $Rth2$ is greater than 0.3 and less than 0.43, it may be determined, according to the foregoing formula (2-2), that the value range of the second length is greater than 277 bits (rounded down) and less than 488 bits (rounded down), or greater than 278 bits (rounded up) and less than 489 bits (rounded up), or greater than 277 bits and less than 489 bits, or greater than 278 bits and less than 488 bits, or the like.

For example, the first codeword length is 648 bits and the second codeword length is 1296 bits. When the first preset coding rate threshold is the same as the second preset coding rate threshold, for example, when $Rth1=Rth2=0.43,$ $L_1$ computed according to the foregoing formula (2-1) is 244 bits (rounded down) or 245 bits (rounded up), and $L_2$ computed according to the foregoing formula (2-2) is 488 bits (rounded down) or 489 bits (rounded up). For another example, when $Rth1=Rth2=0.4,$ $L_1$ computed according to the foregoing formula (2-1) is 216 bits, and $L_2$ computed according to the foregoing formula (2-2) is 432 bits. For another example, when $Rth1=Rth2=0.33,$ $L_1$ computed according to the foregoing formula (2-1) is 159 bits (rounded down) or 160 bits (rounded up), and $L_2$ computed according to the foregoing formula (2-2) is 319 bits (rounded down) or 320 bits (rounded up). For another example, when $Rth1=Rth2=0.3,$ $L_1$ computed according to the foregoing formula (2-1) is 138 bits (rounded down) or 139 bits (rounded up), and $L_2$ computed according to the foregoing formula (2-2) is 277 bits (rounded down) or 278 bits (rounded up).

For another example, the first codeword length is 648 bits and the second codeword length is 1296 bits. When the first preset coding rate threshold is different from the second preset coding rate threshold, for example, when $Rth1=0.32,$ $L_1=152$ bits (rounded down) or 153 bits (rounded up), and when $Rth2=0.4,$ $L_2=432$ bits.

For another example, the first codeword length is 81 bytes and the second codeword length is 162 bytes. When the first preset coding rate threshold is the same as the second preset coding rate threshold, for example, when $Rth1=Rth2=0.43,$ $L_1$ computed according to the foregoing formula (2-1) is 30 bytes or 31 bytes, and $L_2$ computed according to the foregoing formula (2-2) is 61 bytes or 62 bytes. For another example, when $Rth1=Rth2=0.4,$ $L_1=27$ bytes, and $L_2=54$ bytes. For another example, when $Rth1=Rth2=0.32,$ $L_1=19$ bytes or 20 bytes, and $L_2=38$ bytes or 39 bytes. When the first preset coding rate threshold is different from the second preset coding rate threshold, for example, when $Rth1=0.32,$ $L_1=19$ bytes (rounded down) or 20 bytes (rounded up), and when $Rth2=0.4,$ $L_2=54$ bytes.

For another example, the first codeword length is 648 bits and the first length is indicated by using a number of bytes. For example, when $Rth1=0.4,$ $L_1=216$ bits, and a byte size obtained through conversion is $L_1=[216/8]_{Int}=27$ bytes. For another example, when $Rth1=0.32,$ $L_1=152$ bits (rounded down) or 153 bits (rounded up), and a byte size obtained through conversion is 19 bytes (rounded down) or 20 bytes (rounded up). In other words, the first length may be 19 bytes or 20 bytes.

For another example, the first codeword length ($N_1$) is 648 bits. When the value range of the first preset coding rate threshold ($Rth1$) is greater than or equal to 0.3 and less than or equal to 0.43, after being converted into bytes, the first length ($L_1$) computed according to the foregoing formula (2-1) is shown in the following Table 2a. For example, the second codeword length ($N_2$) is 1296 bits. When the value range of the second preset coding rate threshold ($Rth2$) is greater than or equal to 0.3 and less than or equal to 0.43, after being converted into bytes, the second length ($L_2$) computed according to the foregoing formula (2-2) is shown in the following Table 2b.

Table 2a

| First preset coding rate threshold $Rth1$ | First length $L_1$ |
|---|---|
| 0.43 | 30 bytes (rounded down) or 31 bytes (rounded up) |
| 0.42 | 29 bytes (rounded down) or 30 bytes (rounded up) |
| 0.41 | 28 bytes (rounded down) or 29 bytes (rounded up) |
| 0.40 | 27 bytes |
| 0.39 | 25 bytes (rounded down) or 26 bytes (rounded up) |
| 0.38 | 24 bytes (rounded down) or 25 bytes (rounded up) |
| 0.37 | 23 bytes (rounded down) or 24 bytes (rounded up) |
| 0.36 | 22 bytes (rounded down) or 23 bytes (rounded up) |
| 0.35 | 21 bytes (rounded down) or 22 bytes (rounded up) |
| 0.34 | 20 bytes (rounded down) or 21 bytes (rounded up) |
| 0.33 | 19 bytes (rounded down) or 20 bytes (rounded up) |
| 0.32 | 19 bytes (rounded down) or 20 bytes (rounded up) |
| 0.31 | 18 bytes (rounded down) or 19 bytes (rounded up) |
| 0.30 | 17 bytes (rounded down) or 18 bytes (rounded up) |

Table 2b

| Second preset coding rate threshold $Rth2$ | Second length $L_2$ |
|---|---|
| 0.43 | 61 bytes (rounded down) or 62 bytes (rounded up) |
| 0.42 | 58 bytes (rounded down) or 59 bytes (rounded up) |
| 0.41 | 56 bytes (rounded down) or 57 bytes (rounded up) |
| 0.40 | 54 bytes |
| 0.39 | 51 bytes (rounded down) or 52 bytes (rounded up) |
| 0.38 | 49 bytes (rounded down) or 50 bytes (rounded up) |
| 0.37 | 47 bytes (rounded down) or 48 bytes (rounded up) |
| 0.36 | 45 bytes (rounded down) or 46 bytes (rounded up) |
| 0.35 | 43 bytes (rounded down) or 44 bytes (rounded up) |
| 0.34 | 41 bytes (rounded down) or 42 bytes (rounded up) |
| 0.33 | 39 bytes (rounded down) or 40 bytes (rounded up) |
| 0.32 | 38 bytes (rounded down) or 39 bytes (rounded up) |
| 0.31 | 36 bytes (rounded down) or 37 bytes (rounded up) |
| 0.30 | 34 bytes (rounded down) or 35 bytes (rounded up) |

In view of Table 2a and Table 2b, the first length $L_1$ may be any value in Table 2a, and the second length $L_2$ may be any value in Table 2b. The first length $L_1$ and the second length $L_2$ may be randomly combined, including but not limited to: any value combination of $L_1$ and $L_2$ when $Rth1$ and $Rth2$ are the same, and any value combination of $L_1$ and $L_2$ when $Rth1$ and $Rth2$ are different. Due to a space limitation, details are not listed one by one herein.

In addition, for different values of $Rth1$ in Table 2a, the first length $L_1$ may alternatively be rounded up or rounded down to an integer multiple of 5 bytes. Alternatively, for different values of $Rth1$ in Table 2a, the first length $L_1$ may be rounded up or rounded down to an integer multiple of 10 bytes. Details are not described herein again. Similarly, for different values of $Rth2$ in Table 2b, the second length $L_2$ may be further rounded up or rounded down to an integer multiple of 5 bytes. Alternatively, for different values of $Rth2$ in Table 2b, the first length $L_2$ may be rounded up or rounded down to an integer multiple of 10 bytes. Details are not described herein again.

For example, when $Rth1=0.43$, if the first length is rounded up to an integer number of bytes, the first length is 31

**EP 4 607 827 A1**

bytes; or if the first length is rounded up or rounded down to an integer multiple of 5 bytes, the first length is 35 bytes or 30 bytes; or if the first length is rounded up or rounded down to an integer multiple of 10 bytes, the first length is 40 bytes or 30 bytes. When $Rth1=0.3$, if the first length is rounded up or rounded down to an integer number of bytes, the first length is 18 bytes or 17 bytes; or if the first length is rounded up or rounded down to an integer multiple of 5 bytes, the first length is 20 bytes or 15 bytes; or if the first length is rounded up or rounded down to an integer multiple of 10 bytes, the first length is 20 bytes or 10 bytes. Certainly, another value of the first length in Table 2a may alternatively be rounded up or rounded down to an integer multiple of 5 bytes, or rounded up or rounded down to an integer multiple of 10 bytes. The foregoing example is merely an example for description.

For another example, when $Rth2=0.43$, if the second length is rounded up or rounded down to an integer number of bytes, the second length is 62 bytes or 61 bytes; or if the second length is rounded up or rounded down to an integer multiple of 5 bytes, the second length is 65 bytes or 60 bytes; or if the second length is rounded up or rounded down to an integer multiple of 10 bytes, the second length is 70 bytes or 60 bytes. When $Rth2=0.3$, if the second length is rounded up or rounded down to an integer number of bytes, the second length is 35 bytes or 34 bytes; or if the second length is rounded up or rounded down to an integer multiple of 5 bytes, the second length is 35 bytes or 30 bytes; or if the second length is rounded up or rounded down to an integer multiple of 10 bytes, the second length is 40 bytes or 30 bytes. Certainly, another value of the second length in Table 2b may alternatively be rounded up or rounded down to an integer multiple of 5 bytes, or rounded up or rounded down to an integer multiple of 10 bytes. The foregoing example is merely an example for description.

It may be further understood that both the first length $L_1$ and the second length $L_2$ in Table 2a and Table 2b are in a unit of byte. In actual application, the first length $L_1$ in Table 2a may alternatively be in a unit of bit, and the second length $L_2$ in Table 2b may alternatively be in a unit of bit. Units of the first length and the second length are not limited in embodiments of this application.

Optionally, when the first length and the second length are indicated by using a number of bytes, the rounding operation in the foregoing formula (2-1) and/or the foregoing formula (2-2) may be rounding to an integer number of bytes. In some scenarios, when the first length and the second length are indicated by using a number of bytes, the rounding operation in the foregoing formula (2-1) and/or the foregoing formula (2-2) may be rounding up or rounding down to an integer multiple of 5 bytes. In some other scenarios, when the first length and the second length are indicated by using a number of bytes, the rounding operation in the foregoing formula (2-1) and the foregoing formula (2-2) may be rounding up or rounding down to an integer multiple of 10 bytes. Similarly, when the first length and the second length are indicated by using a number of bits, the rounding operation in the foregoing formula (2-1) and/or the foregoing formula (2-2) may be rounding to an integer number of bits, or may be rounding up or rounding down to an integer multiple of 5 bits, or may be rounding up or rounding down to an integer multiple of 10 bits. A specific manner of rounding in the foregoing formula (2-1) and the foregoing formula (2-2) is not limited in embodiments of this application.

For example, the first preset coding rate threshold is the same as the second preset coding rate threshold, and $Rth1=Rth2=0.4$. It is assumed that the first codeword length is 648 bits, the second codeword length is 1296 bits, and the first length and the second length are separately indicated by using a number of bytes. In this case, when Li=216 bits, and $L_2$=432 bits, if rounding to an integer number of bytes is performed, $L_1$=[216/8]$_{Int}$=27 bytes, and $L_2$=[432/8]$_{Int}$=54 bytes. However, if rounding up or rounding down to an integer multiple of 5 bytes is performed, $L_1$=25 bytes or 30 bytes, and $L_2$=50 bytes or 55 bytes. If rounding up or rounding down to an integer multiple of 10 is performed, Li=20 bytes or 30 bytes, and $L_2$=50 bytes or 60 bytes.

For example, a relationship between the length of the to-be-encoded information bit and the length of the LDPC codeword may be shown in at least one row in the following Table 3a or Table 3b. For example, when the length of the to-be-encoded information bit is greater than 0 and less than or equal to $L_1$ bits or $L_1$ bytes, the length of the LDPC codeword is 648 bits. For another example, when the length of the to-be-encoded information bit is greater than or equal to $L_1$ bits or $L_1$ bytes and less than or equal to $L_2$ bits or $L_2$ bytes, the length of the LDPC codeword is 1296 bits. For another example, when the length of the to-be-encoded information bit is greater than or equal to $L_2$ bits or $L_2$ bytes and less than or equal to 648 bits or 81 bytes, the length of the LDPC codeword is 1944 bits. It can be understood that same or similar descriptions below represent same or similar meanings. Details are not described again.

Table 3a and Table 3b may be defined in a standard, or may be preset, or may be determined by both communication entities through negotiation, or the like. "Inf_Num" in Table 3a and Table 3b indicates the length of the to-be-encoded information bit. Same characters in the following descriptions indicate a same meaning. Details are not described again. It can be understood that Table 3a and Table 3b are merely examples. In actual application, a relationship between the length of the to-be-encoded information bit and the length of the LDPC codeword may be a subset in Table 3a or Table 3b. In other words, rows shown in Table 3a may be decoupled from each other, and in actual application, some or all of the rows shown in Table 3a may exist. Similarly, rows shown in Table 3b may be decoupled from each other, and in actual application, some or all of the rows shown in Table 3b may exist.

Table 3a

| Length range of the to-be-encoded information bit (range (bits) of Inf_Num) | LDPC codeword length (LDPC codeword length in bits ($L_{LDPC}$)) |
|---|---|
| 0<Inf Num≤$L_1$ | 648 |
| $L_1$<Inf_Num≤$L_2$ | 1296 |
| $L_2$<Inf_Num≤648 | 1944 |

Table 3b

| Length range of the to-be-encoded information bit (range (bytes) of Inf_Num) | LDPC codeword length (LDPC codeword length in bits ($L_{LDPC}$)) |
|---|---|
| 0<Inf Num≤$L_1$ | 648 |
| $L_1$<Inf_Num≤$L_2$ | 1296 |
| $L_2$<Inf_Num≤81 | 1944 |

It may be understood that, in Table 3a, $L_1$ indicates the first length, $L_2$ indicates the second length, and both $L_1$ and $L_2$ are in a unit of bit. In Table 3b, $L_1$ indicates the first length, $L_2$ indicates the second length, and both $L_1$ and $L_2$ are in a unit of byte.

Optionally, the communication apparatus may determine the length of the LDPC codeword based on the obtained length of the to-be-encoded information bit and at least one row in the foregoing Table 3a or the foregoing Table 3b. The parity-check matrix corresponding to the LDPC codeword is used to encode the to-be-encoded information bit to generate the parity bit. That the communication apparatus determines a length of an LDPC codeword based on the length of the to-be-encoded information bit includes: If the length of the to-be-encoded information bit is greater than 0 and less than or equal to the first length, the communication apparatus determines that the length of the LDPC codeword is 648 bits; if the length of the to-be-encoded information bit is greater than the first length and less than or equal to the second length, the communication apparatus determines that the length of the LDPC codeword is 1296 bits; or if the length of the to-be-encoded information bit is greater than the second length and less than or equal to 648 bits (or 81 bytes), the communication apparatus determines that the length of the LDPC codeword is 1944 bits.

Optionally, after step S102, the communication apparatus may generate the LDPC codeword based on the determined length of the LDPC codeword, the to-be-encoded information bit, the reference coding rate (1/2) of the LDPC codeword, and other information, and transmit the LDPC codeword. The LDPC codeword includes the to-be-encoded information bit and the parity bit generated by encoding the to-be-encoded information bit (or the to-be-encoded information bit and a shortening zero bit) by using the parity-check matrix corresponding to the LDPC codeword. For example, for a manner of generating the LDPC codeword by the communication apparatus, refer to step 1 to step 4 in FIG. 5. For example, the communication apparatus may transmit the LDPC codeword to another communication apparatus, or transmit the LDPC codeword to a next module of the channel coding module for processing. For example, for a manner of transmitting the LDPC codeword by the communication apparatus, refer to step 6 in FIG. 5. In other words, because the UWB system does not include an OFDM symbol, an LDPC encoding process in the UWB system does not include step 5 in FIG. 5.

In this embodiment of this application, a number of shortening zero bits in the LDPC codeword may be determined based on the length of the to-be-encoded information bit and a number of information bits in the LDPC codeword. The number of information bits in the LDPC codeword is determined based on the length of the LDPC codeword and the reference coding rate. Specifically, the number of shortening zero bits is as follows:

$$\text{Padding\_Num}=\text{mod}(K-\text{mod}(\text{Inf\_Num}, K), K)\dots\dots\dots\dots\dots(2\text{-}3)$$

Padding_Num indicates the number of shortening zero bits in the LDPC codeword, K indicates the number of information bits in the LDPC codeword, Inf_Num indicates the length of the to-be-encoded information bit, and mod indicates a modulo operation. A same expression in the following descriptions indicates a same meaning. Details are not described again. K=N×R, where N indicates the length of the generated LDPC codeword, and R indicates the reference coding rate of the LDPC codeword.

It may be understood that, in Table 3a and Table 3b, LDPC codes with code lengths are 648 bits, 1296 bits, and 1944 bits in the WLAN are reused. In some scenarios, to reduce power consumption in the UWB system, only LDPC codes with short and medium code lengths, namely, the LDPC codes with the code lengths of 648 bits and 1296 bits, in the WLAN may be reused. For example, the relationship between the length of the to-be-encoded information bit and the length of the LDPC codeword may meet one or more of the following: If the length of the to-be-encoded information bit is greater than 0 and less than or equal to a first length, the length of the LDPC codeword is 648 bits; if the length of the to-be-encoded information bit is greater than the first length and less than or equal to the second length, the length of the LDPC codeword is 1296 bits; or if the length of the to-be-encoded information bit is greater than the second length and less than or equal to the first value, the length of the LDPC codeword is 1296 bits. The first value may be 648 bits or 81 bytes.

The following describes in detail beneficial effect of embodiments of this application with reference to a design idea of the LDPC codeword length in embodiments of this application.

It can be understood that an LDPC encoding process in a WLAN system is shown in FIG. 5, and all encoded bits of a codeword need to be placed into a to-be-transmitted OFDM symbol. If a number of all encoded bits of the codeword is greater than a number of bits that can be carried in the OFDM symbol, a puncturing operation needs to be performed on the codeword, so that bits obtained by puncturing all the encoded bits of the codeword can be exactly placed into the to-be-transmitted OFDM symbol. If the number of all encoded bits of the codeword is less than the number of bits that can be carried in the OFDM symbol, a repetition operation needs to be performed on some information bits in the codeword to fill the OFDM symbol.

Different from the WLAN system, the UWB system does not include an OFDM symbol. To be specific, during UWB transmission, encoded bits of a codeword do not need to be carried in an OFDM symbol, and therefore some parity bits that may exceed a maximum number of bits that can be carried in an OFDM symbol do not need to be removed through puncturing. Therefore, during selection of a length of an LDPC codeword in the UWB system, performance and coding rate waste (namely, excessive shortening zero bits) need to be considered, but repeated bits (repeat bits) or punctured bits caused by an OFDM symbol do not need to be considered, to be specific, impact of step 5 in FIG. 5 on selection of a length of an LDPC codeword does not need to be considered. In other words, a manner of selecting (or determining) a length of an LDPC codeword in the UWB system is different from a manner of selecting (or determining) a length of an LDPC codeword in the WLAN system. However, a tradeoff between a long code and a short code also needs to be considered during selection (determining) of a length of an LDPC codeword in the UWB system. A reason is as follows: If a long code (for example, an LDPC code with a length of 1944 bits) is always used, better error control performance is achieved, but a large number of shortening zero bits (shortening zero bits) are required for a to-be-encoded information bit with a short length, causing a waste of a coding rate. If a short code (for example, an LDPC code with a length of 648 bits) is always used, for a long data packet, compared with a case in which a long code is used, performance of the long data packet is degraded when the short code is used. In other words, performance loss of the long data packet occurs if the short code is always used.

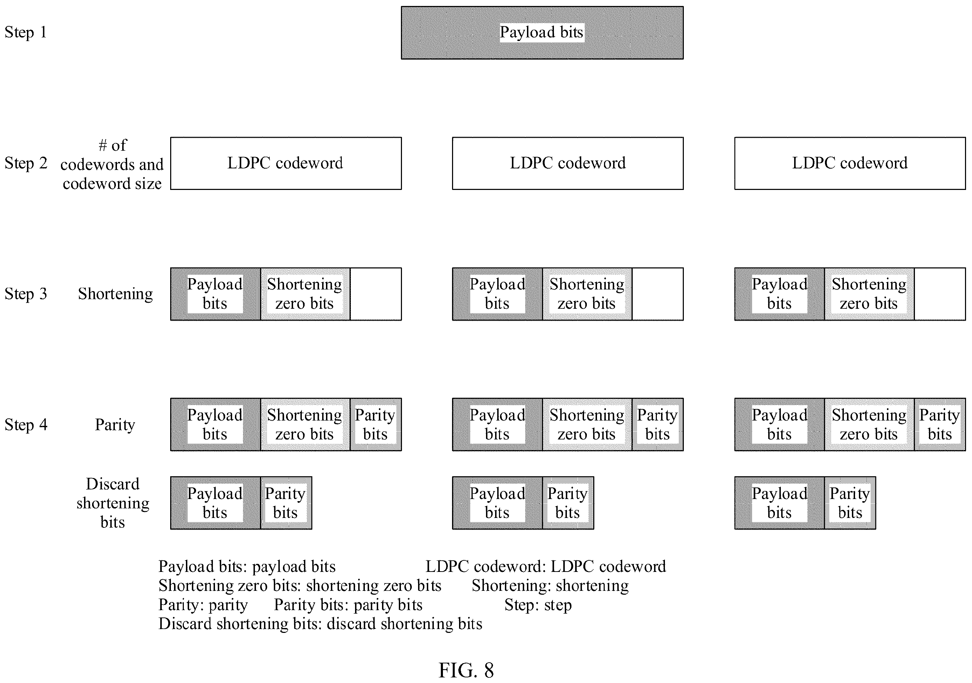

FIG. 8 is a diagram of an LDPC encoding process in a UWB system according to an embodiment of this application. For ease of description, as shown in FIG. 8, for example, to-be-encoded information bits are payload bits. It should be understood that the to-be-encoded information bits in FIG. 8 are not necessarily limited to the payload bits, but may alternatively be a collection of payload bits and CRC bits. In step 3 (step 3), if the to-be-encoded information bits cannot fill information bit positions in an LDPC codeword, zeros need to be added after the to-be-encoded information bits to fill the information bit positions in the LDPC codeword, and then the to-be-encoded information bits and shortening zero bits (shortening zero bits) are encoded by using a parity-check matrix corresponding to the LDPC codeword to generate parity bits. After a complete LDPC codeword is obtained through encoding, as shown in step 4, the shortening zero bits added in step 3 are deleted to obtain a final to-be-transmitted codeword sequence.

As shown in FIG. 8, the shortening operation in step 3 causes a decrease in an actual coding rate of the final to-be-transmitted codeword sequence compared with a reference coding rate of the LDPC codeword. For example, for an LDPC code with a reference coding rate of 1/2 (namely, R=1/2) and a code length of 1944 bits (namely, N=1944), a number of information bits in the LDPC code is as follows: $K=N\times R=1944\times(1/2)=972$ bits; and a number of parity bits is as follows: $M=N\times(1-R)=1944\times(1/2)=972$ bits. If shortening zero bits are 486 bits, an actual coding rate of the LDPC code is as follows: $R'=(972-486)/(972-486+972)=486/1458=1/3$. In this case, a coding rate required for system transmission is 1/2, but the actual coding rate R' of the LDPC code with a length of 1944 bits is 1/3. This causes a waste of a coding rate, and increases overheads of system transmission.

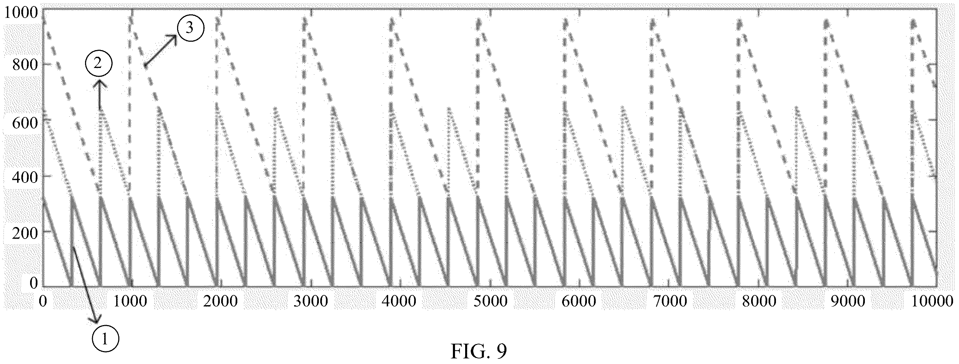

In the manner of computing a number of shortening zero bits in the formula (2-3), when a reference coding rate is fixed at 1/2, a case in which numbers of shortening zero bits required by LDPC codes with three code lengths (648 bits, 1296 bits, and 1944 bits) vary with a length of a to-be-encoded information bit is shown in FIG. 9. In FIG. 9, a horizontal coordinate indicates a length of a to-be-encoded information bit, and a vertical coordinate indicates a number of shortening zero bits. "①" in FIG. 9 indicates a curve of a number of shortening zero bits required by an LDPC code with a reference coding rate of 1/2 and a code length of 648 bits varying with a length of a to-be-encoded information bit. "②" in FIG. 9 indicates a curve of a number of shortening zero bits required by an LDPC code with a reference coding rate of 1/2 and a code length of 1296 bits varying with a length of a to-be-encoded information bit. "③" in FIG. 9 indicates a curve of a number of shortening zero bits required by an LDPC code with a reference coding rate of 1/2 and a code length of 1944 bits varying with a length of a to-be-encoded information bit. To reduce a waste of a coding rate (or transmission overheads), when a length of a to-be-encoded information bit is given, a code length with a smallest number of shortening zero bits may be selected. If LDPC codes with a plurality of code lengths need a same number of shortening zero bits, an LDPC code with a largest code length is selected, because error control performance of a long code is better. For example, when the length of the to-be-encoded information bit ranges from 0 bits to 324 bits, the LDPC code with a length of 648 bits is selected; when the length of the to-be-encoded information bit ranges from 325 bits to 648 bits, the LDPC code with a length of 1296 bits is selected; when the length of the to-be-encoded information bit ranges from 649 bits to 972 bits, the LDPC code with a length of 1944 bits is selected; when the length of the to-be-encoded information bit ranges from 973 bits to 1296 bits, the LDPC code with a length of 1296 bits is selected; when the length of the to-be-encoded information bit ranges from 1297 bits to 1620 bits, the LDPC code with a length of 648 bits is selected; when the length of the to-be-encoded information bit ranges from 1621 bits to 1944 bits, the LDPC code with a length of 1944 bits is selected; and so on.

However, minimization of the number of shortening zero bits causes continuous switching between the three code lengths with an increase in the length of the to-be-encoded information bit. Consequently, a short code is selected for a long data packet (for example, when the length of the to-be-encoded information bit ranges from 1297 bits to 1620 bits, the LDPC code with a length of 648 bits is selected), causing a performance loss. To reduce a performance loss of a long data packet, in embodiments of this application, an effective coding rate may be used to assist in code length selection. The effective coding rate (Rate_E) may be determined based on a length (Inf_Num) of a to-be-encoded information bit, a number (K) of information bits in an LDPC codeword, and a number (M) of parity bits in the LDPC codeword. Specifically, the effective coding rate (Rate_E) may be expressed as follows:

$$Rate\_E = Inf\_Num/Trans\_Bits \dots\dots\dots\dots(2\text{-}4)$$

$$Trans\_Bits = Inf\_Num + (floor((Inf\_Num - 1)/K) + 1) \times M \dots\dots\dots\dots(2\text{-}5)$$

Herein, floor indicates rounding down. K indicates the number of information bits in the LDPC codeword, and M indicates the number of parity bits in the LDPC codeword. $M = (1-R) \times N$, where N indicates a length of a single LDPC codeword.

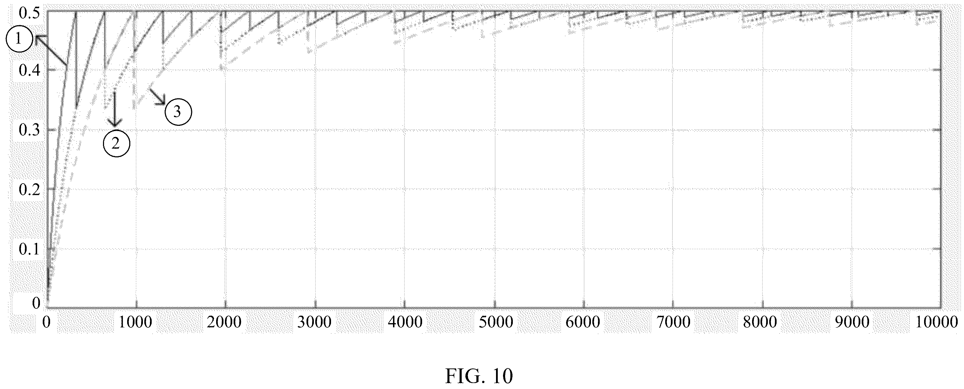

In the manner of computing the effective coding rate (Rate_E) in the formula (2-4), when a reference coding rate is fixed at 1/2, a case in which effective coding rates of LDPC codes with three code lengths (648 bits, 1296 bits, and 1944 bits) vary with a length of a to-be-encoded information bit is shown in FIG. 10. In FIG. 10, a horizontal coordinate indicates a length of a to-be-encoded information bit, and a vertical coordinate indicates an effective coding rate. "①" in FIG. 10 indicates a curve of an effective coding rate of an LDPC code with a reference coding rate of 1/2 and a code length of 648 bits varying with a length of a to-be-encoded information bit. "②" in FIG. 10 indicates a curve of an effective coding rate of an LDPC code with a reference coding rate of 1/2 and a code length of 1296 bits varying with a length of a to-be-encoded information bit. "③" in FIG. 10 indicates a curve of an effective coding rate of an LDPC code with a reference coding rate of 1/2 and a code length of 1944 bits varying with a length of a to-be-encoded information bit. To reduce a performance loss of a long data packet, when a length of a to-be-encoded information bit is given, a code length with a higher effective coding rate may be selected. If LDPC codes with a plurality of code lengths have a same effective coding rate, an LDPC code with a largest code length is selected, because error control performance of a long code is better. For example, when the length of the to-be-encoded information bit ranges from 0 bits to 324 bits, the LDPC code with a length of 648 bits is selected; when the length of the to-be-encoded information bit ranges from 325 bits to 648 bits, the LDPC code with a length of 1296 bits is selected; when the length of the to-be-encoded information bit ranges from 649 bits to 972 bits, the LDPC code with a length of 1944 bits is selected; when the length of the to-be-encoded information bit ranges from 973 bits to 1296 bits, the LDPC code length with a length of 1296 bits is selected; and so on.

It can be understood that, as shown in FIG. 10, the effective coding rate (Rate_E) is increasingly close to the reference coding rate 1/2 with a continuous increase in the length of the to-be-encoded information bit. Therefore, when to-be-encoded information bits are quite long, a coding rate loss caused by shortening zero bits is quite small. To be specific, when to-be-encoded information bits are quite long, an LDPC code with a largest code length (namely, 1944 bits) may be selected. This is because a long code has a higher error control performance gain.

In embodiments of this application, a length of an LDPC codeword is selected based on a tradeoff between an effective coding rate and performance of a long code.

In a possible implementation, a threshold *Rth* of an effective coding rate Rate_E is set, that is, *Rth*1=*Rth*2=*Rth*. Then, a first length (namely, the foregoing formula (2-1)) corresponding to a single LDPC codeword with a reference coding rate of 0.5 and a length of 648 bits may be deduced and a second length (namely, the foregoing formula (2-2)) corresponding to a single LDPC codeword with a reference coding rate of 0.5 and a length of 1296 bits may be deduced according to the computation formula (namely, the foregoing formula (2-4)) of the effective coding rate Rate_E=*Rth*.

When Inf_Num (the length of the to-be-encoded information bit) is less than or equal to 648 bits, an LDPC code with a code length of 648 bits is first selected for encoding. As Inf_Num increases, if the effective coding rate increases to Rate_E>*Rth*, and other code lengths (for example, 1296 bits and 1944 bits) that satisfy Rate_E<*Rth* exist in Inf_Num, a code length (1296 bits) with a high effective coding rate Rate_E is selected from the other code lengths. As Inf_Num continues to increase, if the effective coding rate increases again to Rate_E>*Rth*, and another code length (1944 bits) that satisfies Rate_E<*Rth* exists in Inf_Num, the code length (1944 bits) with a high effective coding rate Rate_E is selected from the another code length.

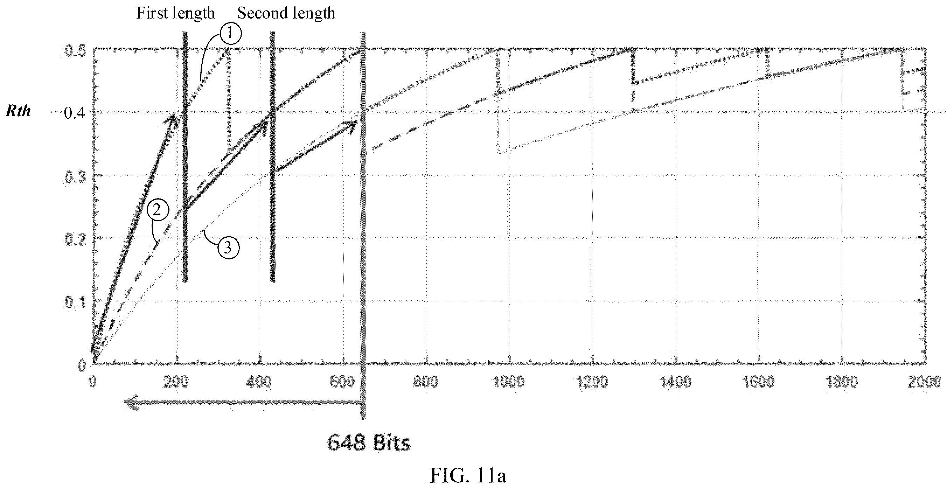

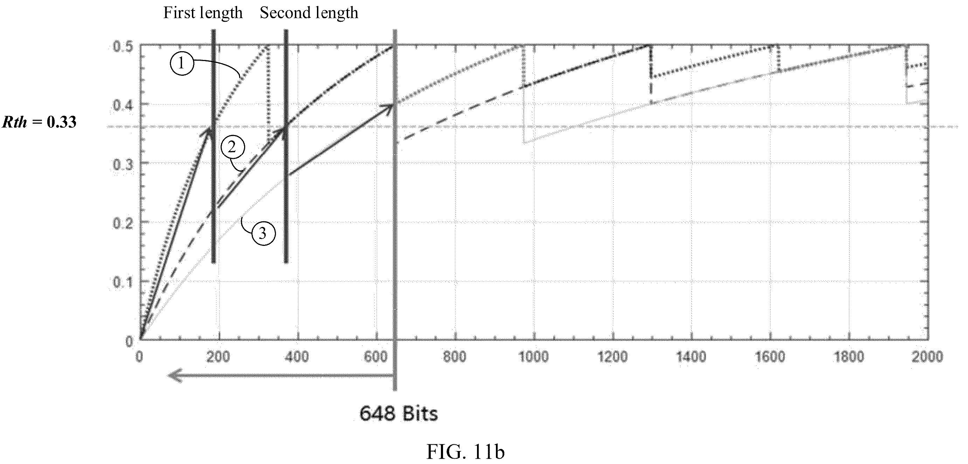

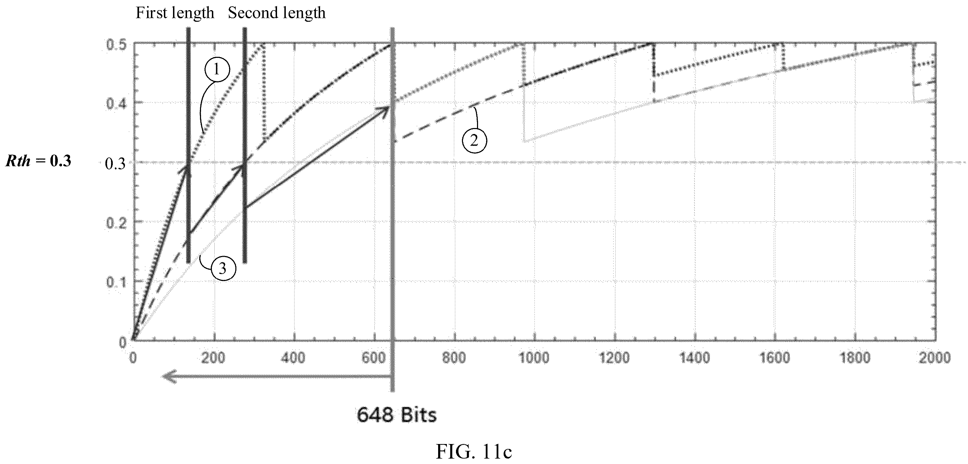

For example, FIG. 11a to FIG. 11c are three diagrams of selecting a length of an LDPC codeword according to an embodiment of this application. In FIG. 11a, *Rth*=0.4 is used as an example. A first value is 648 bits, a first length $L_1$ is 216 bits, and a second length $L_2$ is 432 bits. In FIG. 11b, *Rth*=0.33 is used as an example. A first value is 648 bits. It is assumed that a first length $L_1$ is 160 bits, and a second length $L_2$ is 320 bits. In FIG. 11c, *Rth*=0.3 is used as an example. A first value is 648 bits. It is assumed that a first length $L_1$ is 138 bits, and a second length $L_2$ is 278 bits. In FIG. 11a to FIG. 11c, a horizontal coordinate indicates a length of a to-be-encoded information bit, and a vertical coordinate indicates an effective coding rate. In FIG. 11a to FIG. 11c, "①" indicates a curve of an effective coding rate of an LDPC code with a reference coding rate of 1/2 and a code length of 648 bits varying with a length of a to-be-encoded information bit, "②" indicates a curve of an effective coding rate of an LDPC code with a reference coding rate of 1/2 and a code length of 1296 bits varying with a length of a to-be-encoded information bit, and "③" indicates a curve of an effective coding rate of an LDPC code with a reference coding rate of 1/2 and a code length of 1944 bits varying with a length of a to-be-encoded information bit.

According to the foregoing principle, arrows in FIG. 11a to FIG. 11c separately show selection of a code length. Specifically, as shown in FIG. 11a, when 0<Inf_Num≤216 bits, an LDPC codeword with a code length of 648 bits is selected for encoding. When 216 bits<Inf_Num≤432 bits, an LDPC codeword with a code length of 1296 bits is selected for encoding. When 432 bits<Inf_Num≤648 bits, an LDPC codeword with a code length of 1944 bits is selected for encoding. As shown in FIG. 11b, when 0<Inf_Num≤160 bits, an LDPC codeword with a code length of 648 bits is selected for encoding. When 160 bits<Inf_Num<320 bits, an LDPC codeword with a code length of 1296 bits is selected for encoding. When 320 bits<Inf_Num≤648 bits, an LDPC codeword with a code length of 1944 bits is selected for encoding. As shown in FIG. 11c, when 0<Inf_Num≤138 bits, an LDPC codeword with a code length of 648 bits is selected for encoding. When 138 bits<Inf_Num≤278 bits, an LDPC codeword with a code length is 1296 bits is selected for encoding. When 278 bits<Inf_Num≤648 bits, an LDPC codeword with a code length of 1944 bits is selected for encoding.

In another possible implementation, two thresholds of the effective coding rate Rate_E are set, to be specific, the first preset coding rate threshold *Rth*1 and the second preset coding rate threshold *Rth*2 are different. Then, a first length (namely, the foregoing formula (2-1)) corresponding to a single LDPC codeword with a reference coding rate of 0.5 and a length of 648 bits may be deduced and a second length (namely, the foregoing formula (2-2)) corresponding to a single LDPC codeword with a reference coding rate of 0.5 and a length of 1296 bits may be deduced separately according to the computation formula (the foregoing formula (2-4)) of the effective coding rate Rate_E=*Rth*1 and the effective coding rate Rate_E=*Rth*2.

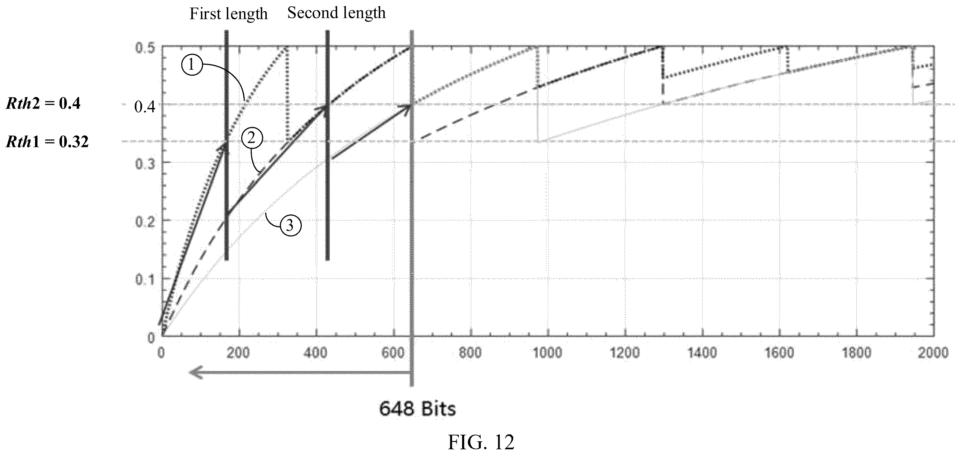

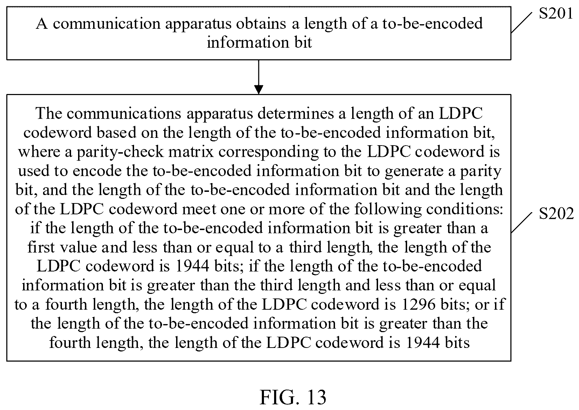

For example, FIG. 12 is yet another diagram of selecting a length of an LDPC codeword according to an embodiment of this application. In FIG. 13, *Rth*1=0.32 and *Rth*2=0.4 are used as an example. A first value is 648 bits. It is assumed that a first length $L_1$ is 152 bits, and a second length $L_2$ is 432 bits. In FIG. 12, a horizontal coordinate indicates a length of a to-be-encoded information bit, and a vertical coordinate indicates an effective coding rate. In FIG. 12, "①" indicates a curve of an effective coding rate of an LDPC code with a reference coding rate of 1/2 and a code length of 648 bits varying with a length of a to-be-encoded information bit, "②" indicates a curve of an effective coding rate of an LDPC code with a reference coding rate of 1/2 and a code length of 1296 bits varying with a length of a to-be-encoded information bit, and "③" indicates a curve of an effective coding rate of an LDPC code with a reference coding rate of 1/2 and a code length of 1944 bits varying with a length of a to-be-encoded information bit. According to the foregoing principle, an arrow in FIG. 12 shows selection of a code length. Specifically, as shown in FIG. 12, when 0<Inf_Num≤152 bits, an LDPC codeword with a code length of 648 bits is selected for encoding. When 152 bits<Inf_Num≤432 bits, an LDPC codeword with a code length of 1296 bits is selected for encoding. When 152 bits<Inf_Num≤648 bits, an LDPC codeword with a code length of 1944 bits is selected for encoding.

It can be learned from FIG. 11a to FIG. 11c and FIG. 12 that, when different values are selected for *Rth*, when the length of the to-be-encoded information bit is greater than the first length and less than or equal to the second length, the LDPC code with a code length of 1296 bits is selected, to achieve a good balance between error control performance and an effective coding rate within the data length range.

Therefore, in the method for determining a length of an LDPC codeword in embodiments of this application, a tradeoff between an effective coding rate and performance of a long code can be achieved, to ensure that a long code is used as much as possible in UWB transmission to obtain a better error control performance gain, and that a coding rate loss caused by excessively shortening zero bits can be avoided when the length of the to-be-encoded information bit is short. In addition, it can be ensured that an effective coding rate of a short packet (for example, the length of the to-be-encoded information bit is less than or equal to 648 bits) is less than a given threshold, to improve short packet performance.

Embodiment 2

Embodiment 2 of this application mainly describes a method for determining a length of an LDPC codeword when a length of to-be-encoded information bit is greater than 648 bits (or 81 bytes).

It may be understood that Embodiment 2 of this application may be jointly implemented with Embodiment 1, or Embodiment 2 of this application may be separately implemented. This is not limited in this application.

FIG. 13 is another schematic flowchart of a method for determining a length of an LDPC codeword in a UWB system according to an embodiment of this application. A communication apparatus in the method may be any device in FIG. 1 or FIG. 2. As shown in FIG. 13, the method for determining a length of an LDPC codeword in a UWB system includes but is not limited to the following steps.

S201: The communication apparatus obtains a length of a to-be-encoded information bit.

In this embodiment of this application, the to-be-encoded information bit may be an information bit that has not undergone channel coding, namely, an information bit input to an input end of a channel coding module. For example, the to-be-encoded information bit may be a to-be-encoded data bit (namely, a payload bit), or the to-be-encoded information bit may include a to-be-encoded data bit and a CRC bit. This is not limited in this embodiment of this application.

S202: The communication apparatus determines a length of an LDPC codeword based on the length of the to-be-encoded information bit, where a parity-check matrix corresponding to the LDPC codeword is used to encode the to-be-encoded information bit to generate a parity bit. The length of the to-be-encoded information bit and the length of the LDPC codeword meet one or more of the following conditions: if the length of the to-be-encoded information bit is greater than a first value and less than or equal to a third length, the length of the LDPC codeword is 1944 bits; if the length of the to-be-encoded information bit is greater than the third length and less than or equal to a fourth length, the length of the LDPC codeword is 1296 bits; or if the length of the to-be-encoded information bit is greater than the fourth length, the length of the LDPC codeword is 1944 bits.

A reference coding rate R of the LDPC codeword is 1/2. The first value may be 648 bits or 81 bytes.

Optionally, the first length and the second length may be indicated by using a number of bits (bits), or may be indicated by using a number of bytes (bytes). This is not limited in embodiments of this application. The third length may be determined based on a third codeword length, the reference coding rate of the LDPC codeword, and a third preset coding rate threshold. The fourth length may be determined based on a second codeword length and a fourth preset coding rate threshold. The third codeword length is 1944 bits or 243 bytes, and the second codeword length is 1296 bits or 162 bytes. The third preset coding rate threshold and the fourth preset coding rate threshold may be the same or may be different. Both the third preset coding rate threshold and the fourth preset coding rate threshold are less than or equal to the reference coding rate R (namely, 0.5).

For example, the third length satisfies the following formula (3-1):

$$L_3 = \left\lceil \frac{N_3 \times (1-R) \times Rth3}{1 - Rth3} \right\rceil_{Int} \quad \text{...............................................................} (3\text{-}1)$$

$L_3$ indicates the third length. A same expression in the following has a same meaning. Details are not described again. $N_3$ indicates the third codeword length, and is equal to 1944 bits or 243 bytes. R indicates the reference coding rate, and is equal to 1/2. $Rth3$ indicates the third preset coding rate threshold, and is less than or equal to 1/2.

For example, the fourth length satisfies the following formula (3-2):

$$L_4 = \left\lceil \frac{N_2 \times Rth4}{1 - Rth4} \right\rceil_{Int} \quad \text{...............................................................} (3\text{-}2)$$

$L_4$ indicates the fourth length. A same expression in the following has a same meaning. Details are not described again. $N_2$ indicates the second codeword length, and is equal to 1296 bits or 162 bytes. $Rth4$ indicates the fourth preset coding rate threshold, and is less than or equal to 1/2.

It may be understood that, if the third codeword length is in a unit of bit, for example, 1944 bits, the third length may alternatively be indicated by using a number of bits. Certainly, the third length may alternatively be indicated by using a number of bytes (where 8 bits=1 byte). For example, a result (in a unit of bit) computed by using the foregoing formula (3-1) is converted into a byte size (if the byte size obtained through the conversion is not an integer, a rounding operation can be performed). If the third codeword length is in a unit of byte, for example, 243 bytes, the third length may alternatively be indicated by using a number of bytes. Certainly, the third length may alternatively be indicated by using a number of bits. Details are not described herein again. Similarly, if the second codeword length is in a unit of bit, for example, 1296 bits, the fourth length may also be indicated by a number of bits (where 1 byte=8 bits). Certainly, the fourth length may alternatively be indicated by a number of bytes, for example, a result (in a unit of bit) computed by using the foregoing formula (3-2) is converted into a byte size (if the byte size obtained through the conversion is not an integer, a rounding operation can be performed). If the second codeword length is in a unit of byte, for example, 162 bytes, the fourth length may alternatively be indicated by using a number of bytes. Certainly, the fourth length may alternatively be indicated by using a number of bits. Details are not described herein again.

Optionally, value ranges of the third preset coding rate threshold $Rth3$ and the fourth preset coding rate threshold $Rth4$ may be both greater than 0.4 and less than or equal to 0.5. Alternatively, a value range of the third preset coding rate threshold $Rth3$ may be a subset in a range that is greater than or equal to 0.4 and less than or equal to 0.5, and a value range of the fourth preset coding rate threshold $Rth4$ may be a subset in a range that is greater than or equal to 0.4 and less than or equal to 0.5.

It may be understood that once the value ranges of the third preset coding rate threshold $Rth3$ and the fourth preset coding rate threshold $Rth4$ are determined, and value ranges of the third length and the fourth length are determined according to the foregoing formula (3-1) and the foregoing formula (3-2). Examples are not listed one by one herein. For example, the third length is indicated by using bits. When the value range of the third preset coding rate threshold $Rth3$ is greater than 0.4 and less than 0.5, it may be determined, according to the foregoing formula (3-1), that the value range of the third length is greater than 648 bits and less than 972 bits. For example, the third length is indicated by using bytes. When the value range of the third preset coding rate threshold $Rth3$ is greater than 0.4 and less than 0.5, it may be determined, according to the foregoing formula (3-1), that the value range of the third length is greater than 81 bytes and less than 121 bytes (rounded down) or 122 bytes (rounded up). Similarly, for example, the fourth length is indicated by using bits. When the value range of the fourth preset coding rate threshold $Rth4$ is greater than 0.4 and less than 0.5, it may be determined, according to the foregoing formula (3-2), that the value range of the fourth length is greater than 864 bits and less than 1296 bits. For example, the fourth length is indicated by using bytes. When the value range of the fourth preset coding rate threshold $Rth4$ is greater than 0.4 and less than 0.5, it may be determined, according to the foregoing formula (3-2), that the value range of the third length is greater than 108 bytes and less than 162 bytes.

In some scenarios, when this embodiment of this application is implemented in combination with Embodiment 1, the first preset coding rate threshold and the second preset coding rate threshold in Embodiment 1 and the third preset coding rate threshold and the fourth preset coding rate threshold in this embodiment of this application may be different, partially the same, or completely the same. This is not limited in embodiments of this application.

For example, the third codeword length is 1944 bits and the second codeword length is 1296 bits. When the third preset coding rate threshold is the same as the fourth preset coding rate threshold, for example, when $Rth3=Rth4=0.43$, $L_3$ computed according to the foregoing formula (3-1) is 733 bits (rounded down) or 734 bits (rounded up), and $L_4$ computed according to the foregoing formula (3-2) is 977 bits (rounded down) or 978 bits (rounded up). For another example, when $Rth3=Rth4=0.45$, $L_3$ computed according to the foregoing formula (3-1) is 795 bits (rounded down) or 796 bits (rounded up), and $L_4$ computed according to the foregoing formula (3-2) is 1063 bits (rounded down) or 1064 bits (rounded down). For another example, when $Rth3=Rth4=0.41$, $L_3$ computed according to the foregoing formula (3-1) is 675 bits or 676 bits, and $L_4$ computed according to the foregoing formula (3-2) is 900 bits or 901 bits. For another example, when $Rth3=Rth4=0.42$, $L_3$ computed according to the foregoing formula (3-1) is 703 bits or 704 bits, and $L_4$ computed according to the foregoing formula (3-2) is 938 bits or 939 bits. For another example, when $Rth3=Rth4=0.5$, $L_3=972$ bits, and $L_4=1296$ bits.

For another example, the third codeword length is 1944 bits and the second codeword length is 1296 bits. When the third preset coding rate threshold is different from the fourth preset coding rate threshold, for example, when $Rth3=0.43$, $L_3=733$ bits (rounded down) or 734 bits (rounded up), and when $Rth4=0.45$, $L_4=1063$ bits.

For another example, the third codeword length is 243 bytes and the second codeword length is 162 bytes. When the third preset coding rate threshold is the same as the third preset coding rate threshold, for example, when $Rth3=Rth4=0.45$, $L_3=99$ bytes or 100 bytes, and $L_4=132$ bytes or 133 bytes. When the third preset coding rate threshold is different from the fourth preset coding rate threshold, for example, when $Rth3=0.43$, $L_3=91$ bytes or 92 bytes, and when $Rth4=0.48$, $L_4=149$ bytes or 150 bytes.

For another example, the third codeword length is 1944 bits and the third length is indicated by using a number of bytes. For example, when $Rth3=0.43$, $L_3=733$ bits or 734 bits, and a byte size obtained through conversion is 91 bytes or 92 bytes.

Optionally, similar to the foregoing embodiment, when the third length and the fourth length are indicated by using a number of bytes, the rounding operation in the foregoing formula (3-1) and/or the foregoing formula (3-2) may be rounding to an integer number of bytes. In some scenarios, when the third length and the fourth length are indicated by using a number of bytes, the rounding operation in the foregoing formula (3-1) and/or the foregoing formula (3-2) may be rounding up or rounding down to an integer multiple of 5 bytes. In some other scenarios, when the third length and the fourth length are indicated by using a number of bytes, the rounding operation in the foregoing formula (3-1) and the foregoing formula (3-2) may be rounding up or rounding down to an integer multiple of 10 bytes. Similarly, when the third length and the fourth length are indicated by using a number of bits, the rounding operation in the foregoing formula (3-1) and/or the foregoing formula (3-2) may be rounding to an integer number of bits, or may be rounding up or rounding down to an integer multiple of 5 bits, or may be rounding up or rounding down to an integer multiple of 10 bits. A specific manner of rounding in the foregoing formula (3-1) and the foregoing formula (3-2) is not limited in embodiments of this application.

For example, the third preset coding rate threshold is the same as the fourth preset coding rate threshold, and $Rth3=Rth4=0.43$. It is assumed that the third codeword length is 1944 bits, the second codeword length is 1296 bits, and the third length and the fourth length are separately indicated by using a number of bytes. In this case, $L_3$=733 bits (rounded down) or 734 bits (rounded up), and $L_4$=977 bits (rounded down), or 978 bits (rounded up). If rounding to an integer number of bytes is performed, the third length is $[733/8]_{Int}$ or $[734/8]_{Int}$, namely, 91 bytes or 92 bytes, and the fourth length is $[977/8]_{Int}$ or $[978/8]_{Int}$, namely, 122 bytes or 123 bytes. However, if rounding up or rounding down to an integer multiple of 5 bytes is performed, the third length is 90 bytes or 95 bytes, and the fourth length is 120 bytes or 125 bytes. If rounding up or rounding down to an integer multiple of 10 bytes is performed, the third length is 90 bytes or 100 bytes, and the fourth length is 120 bytes or 130 bytes.

For example, a relationship between the length of the to-be-encoded information bit and the length of the LDPC codeword may be shown in at least one row in the following Table 4 or Table 5. Table 4 and Table 5 may be defined in a standard, or may be preset, or may be determined by both communication entities through negotiation, or the like. "Inf_Num" in Table 4 and Table 5 indicates the length of the to-be-encoded information bit. Same characters in the following descriptions indicate a same meaning. Details are not described again. It can be understood that Table 4 and Table 5 are merely examples. In actual application, the relationship between the length of the to-be-encoded information bit and the length of the LDPC codeword may be a subset in Table 4 or Table 5. In other words, rows shown in Table 4 may be decoupled from each other, and in actual application, some or all of the rows shown in Table 4 may exist. Similarly, rows shown in Table 5 may be decoupled from each other, and in actual application, some or all of the rows shown in Table 5 may exist.

Table 4

| Length range of the to-be-encoded information bit (range (bits) of Inf_Num) | LDPC codeword length (LDPC codeword length in bits ($L_{LDPC}$)) |
|---|---|
| $648<$Inf Num$\leq L_3$ | 1944 |
| $L_3<$Inf_Num$\leq L_4$ | 1296 |
| $L_4<$Inf_Num | 1944 |

Table 5

| Length range of the to-be-encoded information bit (range (bytes) of Inf_Num) | LDPC codeword length (LDPC codeword length in bits ($L_{LDPC}$)) |
|---|---|
| $81<$Inf_Num$\leq L_3$ | 1944 |
| $L_3<$Inf_Num$\leq L_4$ | 1296 |
| $L_4<$Inf_Num | 1944 |

It may be understood that, in Table 4, $L_3$ indicates the third length, $L_4$ indicates the fourth length, and both $L_3$ and $L_4$ are in a unit of bit. In Table 5, $L_3$ indicates the third length, $L_4$ indicates the fourth length, and both $L_3$ and $L_4$ are in a unit of byte.

Optionally, the communication apparatus may determine the length of the LDPC codeword based on the obtained length of the to-be-encoded information bit and at least one row in the foregoing Table 4 or the foregoing Table 5. The parity-check matrix corresponding to the LDPC codeword is used to encode the to-be-encoded information bit to generate the parity bit. That the communication apparatus determines a length of an LDPC codeword based on the length of the to-be-encoded information bit includes: If the length of the to-be-encoded information bit is greater than 648 bits (or 81 bytes) and less than or equal to the third length, the communication apparatus determines that the length of the LDPC codeword is 1944 bits; if the length of the to-be-encoded information bit is greater than the third length and less than or equal to the fourth length, the communication apparatus determines that the length of the LDPC codeword is 1296 bits; or if the length of the to-be-encoded information bit is greater than the fourth length, the communication apparatus determines that the length of the LDPC codeword is 1944 bits.

Optionally, after step S202, the communication apparatus may generate the LDPC codeword based on the determined length of the LDPC codeword, the to-be-encoded information bit, the reference coding rate (1/2) of the LDPC codeword, and other information, and transmit the LDPC codeword. The LDPC codeword includes the to-be-encoded information bit and the parity bit generated by encoding the to-be-encoded information bit (or the to-be-encoded information bit and a shortening zero bit) by using the parity-check matrix corresponding to the LDPC codeword. For example, for a manner of generating the LDPC codeword by the communication apparatus, refer to step 1 to step 4 in FIG. 5. For example, the communication apparatus may transmit the LDPC codeword to another communication apparatus, or transmit the LDPC codeword to a next module of the channel coding module for processing. For example, for a manner of transmitting the LDPC codeword by the communication apparatus, refer to step 6 in FIG. 5. In other words, because the UWB system does not include an OFDM symbol, an LDPC encoding process in the UWB system does not include step 5 in FIG. 5.

In this embodiment of this application, a number of shortening zero bits in the LDPC codeword may be determined based on the length of the to-be-encoded information bit and a number of information bits in the LDPC codeword. The number of information bits in the LDPC codeword is determined based on the length of the LDPC codeword and the reference coding rate. Specifically, the number of shortening zero bits is determined according to the formula (2-3).

It may be understood that a design idea of the length of the LDPC codeword in this embodiment of this application is similar to the design idea of the length of the LDPC codeword in Embodiment 1.

Specifically, two thresholds: $Rth3$ and $Rth4$ of the effective coding rate Rate_E are set, and the third length (648 bits (or 81 bytes)$<L_3 \leq 972$ bits (121 bytes or 122 bytes)) and the fourth length ($L_4 > L_3$) are computed based on the two thresholds and the foregoing formula (3-1) and formula (3-2).

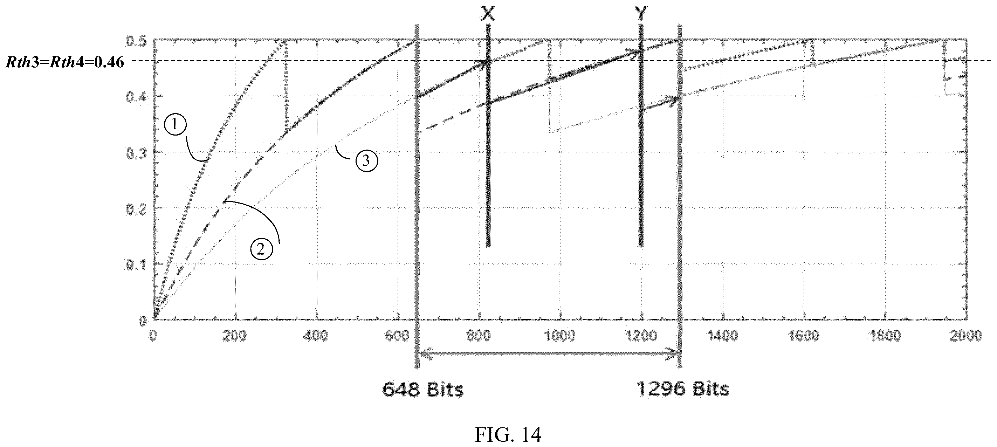

For example, FIG. 14 is still yet another diagram of selecting a length of an LDPC codeword according to an embodiment of this application. In FIG. 14, $Rth3=Rth4=0.46$ is used as an example. The first value is 648 bits, the third length $L_3$ is 828 bits, and the fourth length $L_4$ is 1104 bits. In FIG. 14, a horizontal coordinate indicates a length of a to-be-encoded information bit, and a vertical coordinate indicates an effective coding rate. In FIG. 14, "①" indicates a curve of an effective coding rate of an LDPC code with a reference coding rate of 1/2 and a code length of 648 bits varying with a length of a to-be-encoded information bit, "②" indicates a curve of an effective coding rate of an LDPC code with a reference coding rate of 1/2 and a code length of 1296 bits varying with a length of a to-be-encoded information bit, and "③" indicates a curve of an effective coding rate of an LDPC code with a reference coding rate of 1/2 and a code length of 1944 bits varying with a length of a to-be-encoded information bit. In addition, in FIG. 14, "X" indicates the third length, and "Y" indicates the fourth length.

According to a principle similar to that in Embodiment 1, an arrow in FIG. 14 shows selection of a code length. Specifically, as shown in FIG. 14, when 648 bits<Inf_Num<828 bits, an LDPC codeword with a code length of 1944 bits is selected for encoding. When 828 bits<Inf_Num≤1104 bits, an LDPC codeword with a code length of 1296 bits is selected for encoding. When 1104 bits<Inf_Num≤1296 bits, an LDPC codeword with a code length of 1944 bits is selected for encoding.

It can be learned from FIG. 14 that, when the length of the to-be-encoded information bit is greater than the third length and less than or equal to the fourth length, the LDPC code with a code length of 1296 bits is selected, to achieve a good balance between error control performance and an effective coding rate within the data length range.

For beneficial effect of this embodiment of this application, refer to the beneficial effect of Embodiment 1. Specifically, in this embodiment of this application, a tradeoff is still made between the effective coding rate and performance of a long code, to ensure that a long code is used as much as possible in UWB transmission to achieve a higher error control performance gain, and avoid a coding rate loss caused by excessive shortening zero bits when a length of a to-be-encoded information bit is small.

The foregoing content describes in detail the method provided in this application. To facilitate implementation of the foregoing solutions in embodiments of this application, embodiments of this application further provide a corresponding apparatus or device.

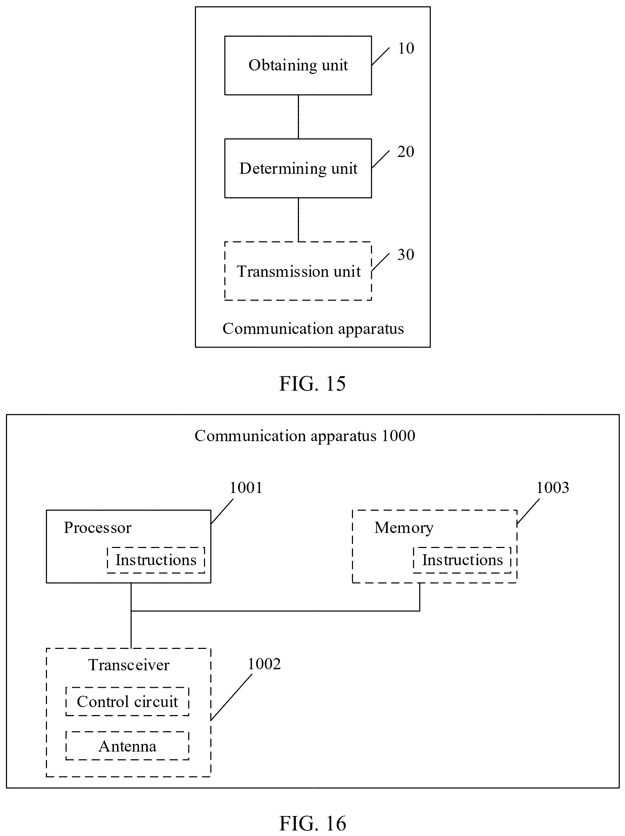

In this application, the communication apparatus is divided into functional modules based on the foregoing method embodiments. For example, each functional module may be divided to each corresponding function, or two or more functions may be integrated into one processing module. The foregoing integrated module may be implemented in a form of hardware, or may be implemented in a form of software function module. It should be noted that, in this application, module division is an example, and is merely a logical function division. In actual implementation, another division manner may be used. The communication apparatus in embodiments of this application is described below in detail with reference to FIG. 15 to FIG. 17.

FIG. 15 is a diagram of a structure of a communication apparatus according to an embodiment of this application. As shown in FIG. 15, the communication apparatus includes an obtaining unit 10 and a determining unit 20. Optionally, the communication apparatus further includes a transmission unit 30.

In a design, the obtaining unit 10 is configured to obtain a length of a to-be-encoded information bit. The determining unit 20 is configured to determine a length of an LDPC codeword based on the length of the to-be-encoded information bit, where a parity-check matrix corresponding to the LDPC codeword is used to encode the to-be-encoded information bit to generate a parity bit. The length of the to-be-encoded information bit and the length of the LDPC codeword meet one or more of the following conditions: If the length of the to-be-encoded information bit is greater than 0 and less than or equal to a first length, the length of the LDPC codeword is 648 bits; if the length of the to-be-encoded information bit is greater than the first length and less than or equal to a second length, the length of the LDPC codeword is 1296 bits; or if the length of the to-be-encoded information bit is greater than the second length and less than or equal to a first value, the length of the LDPC codeword is 1944 bits. At least one of the first length or the second length is determined based on a preset coding rate threshold.

In a possible implementation, the transmission unit 30 is configured to transmit the LDPC codeword, where the LDPC codeword includes the to-be-encoded information bit and the parity bit.

In another design, the obtaining unit 10 is configured to obtain a length of a to-be-encoded information bit. The determining unit 20 is configured to determine a length of an LDPC codeword based on the length of the to-be-encoded information bit, where a parity-check matrix corresponding to the LDPC codeword is used to encode the to-be-encoded information bit to generate a parity bit. The length of the to-be-encoded information bit and the length of the LDPC codeword meet one or more of the following conditions: If the length of the to-be-encoded information bit is greater than the first value and less than or equal to a third length, the length of the LDPC codeword is 1944 bits; if the length of the to-be-encoded information bit is greater than the third length and less than or equal to a fourth length, the length of the LDPC codeword is 1296 bits; or if the length of the to-be-encoded information bit is greater than the fourth length, the length of the LDPC codeword is 1944 bits, where the first value is 648 bits or 81 bytes. At least one of the third length or the fourth length is determined based on a preset coding rate threshold.

In a possible implementation, the transmission unit 30 is configured to transmit the LDPC codeword, where the LDPC codeword includes the to-be-encoded information bit and the parity bit.

The obtaining unit 10, the determining unit 20, and the transmission unit 30 may be integrated into one unit or module, for example, a processing unit. Optionally, the transmission unit 30 may be a transceiver, a transceiver unit, or the like.

In this embodiment of this application, for specific descriptions of the first value, the first length, the second length, the third length, the fourth length, the preset coding rate threshold, and the like, refer to the foregoing method embodiments (including FIG. 7 and FIG. 13). Details are not described herein again.

It should be understood that, for specific functions of or steps performed by the foregoing units, refer to the method embodiments. Details are not described herein again.

The foregoing describes the communication apparatuses in embodiments of this application. The following describes a possible product form of the communication apparatus. It should be understood that a product in any form that has a function of the communication apparatus in FIG. 15 falls within the protection scope of embodiments of this application. It should be further understood that the following descriptions are merely examples, and do not limit a product form of the communication apparatus in embodiments of this application.

In the communication apparatus shown in FIG. 15, the obtaining unit 10, the determining unit 20, and the transmission unit 30 may be implemented by using one or more processors. FIG. 16 is a diagram of a structure of a communication apparatus 1000 according to an embodiment of this application. FIG. 16 shows only main components in the communication apparatus 1000. In addition to a processor 1001, the communication apparatus may further include a transceiver 1002, a memory 1003, and an input/output apparatus (not shown in the figure). The processor 1001 and the transceiver 1002 may be coupled to each other, or the like. A manner of connection between the processor and the transceiver is not limited in this embodiment of this application.

The processor 1001 is mainly configured to: process a communication protocol and communication data, control the entire communication apparatus, execute a software program, and process data of the software program. The memory 1003 is mainly configured to store the software program and data. The transceiver 1002 may include a control circuit and an antenna. The control circuit is mainly configured to: perform conversion between a baseband signal and a radio frequency signal, and process the radio frequency signal. The antenna is mainly configured to: receive and send a radio frequency signal in a form of an electromagnetic wave. The input/output apparatus, for example, a touchscreen, a display, or a keyboard, is mainly configured to receive data entered by a user, and output data to the user.

After the communication apparatus is powered on, the processor 1001 may read the software program in the memory 1003, interpret and execute instructions of the software program, and process the data of the software program. When data needs to be sent in a wireless manner, the processor 1001 performs baseband processing on the to-be-sent data, and outputs a baseband signal to a radio frequency circuit. The radio frequency circuit performs radio frequency processing on the baseband signal, and then sends a radio frequency signal to the outside through the antenna in a form of an electromagnetic wave. When data is sent to the communication apparatus, the radio frequency circuit receives a radio frequency signal through the antenna, converts the radio frequency signal into a baseband signal, and outputs the baseband signal to the processor 1001. The processor 1001 converts the baseband signal into data, and processes the data.

In another implementation, the radio frequency circuit and the antenna may be disposed independent of the processor that performs baseband processing. For example, in a distributed scenario, the radio frequency circuit and the antenna may be disposed remotely and independent of the communication apparatus.

The processor 1001, the transceiver 1002, and the memory 1003 may be connected through a communication bus.

In a design, the communication apparatus 1000 may be configured to perform the functions in Embodiment 1. The processor 1001 may be configured to perform step S101 and step S102 in FIG. 7, and/or configured to perform another process of the technology described in this specification. The transceiver 1002 may be configured to send and receive information, data, or the like required in FIG. 7, and/or configured to perform another process of the technology described in this specification.

In another design, the communication apparatus 1000 may be configured to perform the functions in Embodiment 2. The processor 1001 may be configured to perform step S201 and step S202 in FIG. 13, and/or configured to perform another process of the technology described in this specification. The transceiver 1002 may be configured to send and receive information, data, or the like required in FIG. 13, and/or configured to perform another process of the technology described in this specification.

In any one of the foregoing designs, the processor 1001 may include a transceiver configured to implement receiving and sending functions. For example, the transceiver may be a transceiver circuit, an interface, or an interface circuit. The transceiver circuit, the interface, or the interface circuit configured to implement the receiving and sending functions may be separated, or may be integrated together. The transceiver circuit, the interface, or the interface circuit may be configured to read and write code/data. Alternatively, the transceiver circuit, the interface, or the interface circuit may be configured to transmit or transfer a signal.

In any one of the foregoing designs, the processor 1001 may store instructions. The instruction may be a computer program. The computer program is run on the processor 1001, so that the communication apparatus 1000 can perform the method described in the foregoing method embodiments. The computer program may be fixed in the processor 1001. In this case, the processor 1001 may be implemented by hardware.

In an implementation, the communication apparatus 1000 may include a circuit. The circuit may implement the sending, receiving, or communication function in the foregoing method embodiments. The processor and the transceiver described in this application may be implemented on an integrated circuit (integrated circuit, IC), an analog IC, a radio frequency integrated circuit (radio frequency integrated circuit, RFIC), a mixed-signal IC, an application-specific integrated circuit (application-specific integrated circuit, ASIC), a printed circuit board (printed circuit board, PCB), an electronic device, or the like. The processor and the transceiver may alternatively be manufactured by using various IC technologies, for example, a complementary metal-oxide-semiconductor (complementary metal-oxide-semiconductor, CMOS), an N-channel metal-oxide-semiconductor (N-channel Metal-oxide-semiconductor, NMOS), a positive-channel metal-oxide-semiconductor (positive-channel metal-oxide-semiconductor, PMOS), a bipolar junction transistor (bipolar junction transistor, BJT), a bipolar CMOS (BiCMOS), silicon germanium (SiGe), and gallium arsenide (GaAs).

It may be understood that the communication apparatus shown in this embodiment of this application may alternatively include more components than those shown in FIG. 16, or the like. This is not limited in this embodiment of this application. The foregoing methods performed by the processor and the transceiver are merely examples. For specific steps performed by the processor and the transceiver, refer to the descriptions in the foregoing method embodiments.

For example, a scope of the communication apparatus described in this application is not limited thereto, and the structure of the communication apparatus may not be limited in FIG. 16. The communication apparatus may be an independent device or may be a part of a large device. For example, the communication apparatus may be:

(1) an independent integrated circuit IC, a chip, or a chip system or subsystem;
(2) a set including one or more ICs, where optionally, the set of ICs may further include a storage component configured to store data and a computer program;
(3) an ASIC, for example, a modem (Modem);
(4) a module that can be embedded in another device;
(5) a receiver, a terminal, an intelligent terminal, a cellular phone, a wireless device, a handheld device, a mobile unit, a vehicle-mounted device, a network device, a cloud device, or an artificial intelligence device; or
(6) others.

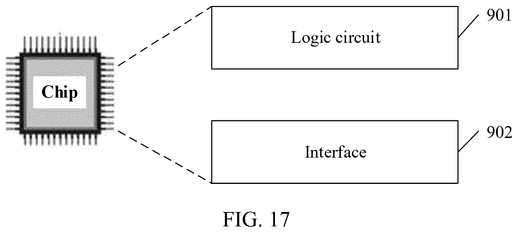

In another possible implementation, in the communication apparatus shown in FIG. 15, the obtaining unit 10 and the determining unit 20 may be implemented by using one or more logic circuits, and the transmission unit 30 may be an input/output interface, also referred to as a communication interface, an interface circuit, an interface, or the like. Alternatively, the transmission unit 30 may be a sending unit and a receiving unit. The sending unit may be an output interface, and the receiving unit may be an input interface. The sending unit and the receiving unit are integrated into one unit, for example, an input/output interface. FIG. 17 is a diagram of another structure of a communication apparatus according to an embodiment of this application. As shown in FIG. 17, the communication apparatus shown in FIG. 17 includes a logic circuit 901 and an interface 902. The logic circuit 901 may be a chip, a processing circuit, an integrated circuit, a system on chip (system on chip, SoC) chip, or the like. The interface 902 may be a communication interface, an input/output interface, a pin, or the like. For example, FIG. 17 shows an example in which the communication apparatus is a chip. The chip includes the logic circuit 901 and the interface 902.

In this embodiment of this application, the logic circuit and the interface may be coupled to each other. A specific manner of connection between the logical circuit and the interface is not limited in this embodiment of this application.

For example, when the communication apparatus is configured to perform the method, the functions, or the steps performed by the communication apparatus in Embodiment 1, the logic circuit 901 is configured to obtain a length of a to-be-encoded information bit, and determine a length of a low-density parity-check LDPC codeword based on the length of the to-be-encoded information bit, where a parity-check matrix corresponding to the LDPC codeword is used to encode the to-be-encoded information bit to generate a parity bit. The interface 902 is configured to output the LDPC codeword, where the LDPC codeword includes the to-be-encoded information bit and the parity bit. The length of the to-be-encoded information bit and the length of the LDPC codeword meet one or more of the following conditions: If the length of the to-be-encoded information bit is greater than 0 and less than or equal to a first length, the length of the LDPC codeword is 648 bits; if the length of the to-be-encoded information bit is greater than the first length and less than or equal to a second length, the length of the LDPC codeword is 1296 bits; or if the length of the to-be-encoded information bit is greater than the second length and less than or equal to a first value, the length of the LDPC codeword is 1944 bits. At least one of the first length or the second length is determined based on a preset coding rate threshold.

For example, when the communication apparatus is configured to perform the method, the functions, or the steps performed by the communication apparatus in Embodiment 2, the logic circuit 901 is configured to obtain a length of a to-be-encoded information bit, and determine a length of a low-density parity-check LDPC codeword based on the length of the to-be-encoded information bit, where a parity-check matrix corresponding to the LDPC codeword is used to encode the to-be-encoded information bit to generate a parity bit. The interface 902 is configured to output the LDPC codeword, where the LDPC codeword includes the to-be-encoded information bit and the parity bit. The length of the to-be-encoded information bit and the length of the LDPC codeword meet one or more of the following conditions: If the length of the to-be-encoded information bit is greater than the first value and less than or equal to a third length, the length of the LDPC codeword is 1944 bits; if the length of the to-be-encoded information bit is greater than the third length and less than or equal to a fourth length, the length of the LDPC codeword is 1296 bits; or if the length of the to-be-encoded information bit is greater than the fourth length, the length of the LDPC codeword is 1944 bits, where the first value is 648 bits or 81 bytes. At least one of the third length or the fourth length is determined based on a preset coding rate threshold.

In this embodiment of this application, for specific descriptions of the first value, the first length, the second length, the third length, the fourth length, the preset coding rate threshold, and the like, refer to the foregoing method embodiments (including FIG. 7 and FIG. 13). Details are not described herein again.

It may be understood that the communication apparatus shown in embodiments of this application may implement the method provided in embodiments of this application in a form of hardware, may implement the method provided in embodiments of this application in a form of software, or the like. This is not limited in embodiments of this application.

For specific implementations of embodiments shown in FIG. 17, further refer to the foregoing embodiments. Details are not described herein again.

This application further provides a computer program. The computer program is used to implement operations and/or processing performed by the communication apparatus in the method provided in this application.

This application further provides a computer-readable storage medium. The computer-readable storage medium stores computer code. When the computer code is run on a computer, the computer is enabled to perform operations and/or processing performed by the communication apparatus in the method provided in this application.

This application further provides a computer program product. The computer program product includes computer code or a computer program. When the computer code or the computer program is run on a computer, operations and/or processing performed by the communication apparatus in the methods provided in this application are/is performed.

In the several embodiments provided in this application, it should be understood that the disclosed system, apparatus, and method may be implemented in other manners. For example, the described apparatus embodiment is merely an example. For example, division into the units is merely logical function division and may be other division in actual implementation. For example, a plurality of units or components may be combined or integrated into another system, or some features may be ignored or not performed. In addition, the displayed or discussed mutual couplings or direct couplings or communication connections may be implemented through some interfaces, indirect couplings or communication connections between the apparatuses or units, or electrical connections, mechanical connections, or connections in other forms.

The units described as separate parts may or may not be physically separate, and parts displayed as units may or may not be physical units, may be located in one position, or may be distributed on a plurality of network units. Some or all of the units may be selected based on an actual requirement to implement the technical effect of the solutions provided in embodiments of this application.

In addition, function units in embodiments of this application may be integrated into one processing unit, each of the units may exist alone physically, or two or more units may be integrated into one unit. The integrated unit may be implemented in a form of hardware, or may be implemented in a form of a software function unit.

When the integrated unit is implemented in the form of the software functional unit and sold or used as an independent product, the integrated unit may be stored in a computer-readable storage medium. Based on such an understanding, the technical solutions of this application essentially, or the part contributing to the conventional technologies, or all or some of the technical solutions may be implemented in a form of a software product. The computer software product is stored in a readable storage medium and includes several instructions for instructing a computer device (which may be a personal computer, a server, a network device, or the like) to perform all or some of the steps of the methods described in embodiments of this application. The readable storage medium includes any medium that can store program code, for example, a USB flash drive, a removable hard disk, a read-only memory (read-only memory, ROM), a random access memory (random access memory, RAM), a magnetic disk, or an optical disc.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

**Claims**

1. A method for determining a length of a low-density parity-check codeword in an ultra-wideband system, comprising:

   obtaining, by a communication apparatus, a length of a to-be-encoded information bit; and
   determining, by the communication apparatus, a length of a low-density parity-check LDPC codeword based on the length of the to-be-encoded information bit, wherein a parity-check matrix corresponding to the LDPC codeword is used to encode the to-be-encoded information bit to generate a parity bit, wherein
   the length of the to-be-encoded information bit and the length of the LDPC codeword meet one or more of the following conditions: if the length of the to-be-encoded information bit is greater than 0 and less than or equal to a first length, the length of the LDPC codeword is 648 bits; if the length of the to-be-encoded information bit is greater than the first length and less than or equal to a second length, the length of the LDPC codeword is 1296 bits; or if the length of the to-be-encoded information bit is greater than the second length and less than or equal to a first value, the length of the LDPC codeword is 1944 bits, wherein
   at least one of the first length or the second length is determined based on a preset coding rate threshold.

2. The method according to claim 1, wherein a reference coding rate of the LDPC codeword is 1/2.

3. The method according to claim 1 or 2, wherein the first value is 648 bits or 81 bytes.

4. The method according to any one of claims 1 to 3, wherein that the first length is determined based on a preset coding rate threshold comprises:
   the first length is determined based on a first codeword length, the reference coding rate of the LDPC codeword, and a first preset coding rate threshold, the first codeword length is 648 bits or 81 bytes, and the first preset coding rate threshold is less than the reference coding rate of the LDPC codeword.

5. The method according to claim 4, wherein the first length satisfies:

$$L_1 = \left\lceil \frac{N_1 \times (1-R) \times Rth1}{1 - Rth1} \right\rceil_{Int},$$

   wherein
   $L_1$ indicates the first length, $N_1$ indicates the first codeword length, R indicates the reference coding rate of the LDPC codeword, $Rth1$ indicates the first preset coding rate threshold, and $[x]_{int}$ indicates rounding x.

6. The method according to any one of claims 1 to 5, wherein that the second length is determined based on a preset coding rate threshold comprises:
   the second length is determined based on a second codeword length, the reference coding rate of the LDPC codeword, and a second preset coding rate threshold, the second codeword length is 1296 bits or 162 bytes, and the second preset coding rate threshold is less than the reference coding rate of the LDPC codeword.

7.  The method according to claim 6, wherein the second length satisfies:

$$L_2 = \left\lceil \frac{N_2 \times (1-R) \times Rth2}{1-Rth2} \right\rceil_{Int},$$

wherein
$L_2$ indicates the second length, $N_2$ indicates the second codeword length, R indicates the reference coding rate of the LDPC codeword, $Rth2$ indicates the second preset coding rate threshold, and $[x]_{int}$ indicates rounding x.

8.  The method according to any one of claims 1 to 7, wherein the first preset coding rate threshold is the same as the second preset coding rate threshold.

9.  The method according to any one of claims 1 to 8, wherein the length of the to-be-encoded information bit and the length of the LDPC codeword further meet one or more of the following conditions:

    if the length of the to-be-encoded information bit is greater than the first value and less than or equal to a third length, the length of the LDPC codeword is 1944 bits; if the length of the to-be-encoded information bit is greater than the third length and less than or equal to a fourth length, the length of the LDPC codeword is 1296 bits; or if the length of the to-be-encoded information bit is greater than the fourth length, the length of the LDPC codeword is 1944 bits, wherein
    at least one of the third length or the fourth length is determined based on a preset coding rate threshold.

10. The method according to claim 9, wherein that the third length is determined based on a preset coding rate threshold comprises:
    the third length is determined based on a third codeword length, the reference coding rate of the LDPC codeword, and a third preset coding rate threshold, the third codeword length is 1944 bits or 243 bytes, and the third preset coding rate threshold is less than the reference coding rate of the LDPC codeword.

11. The method according to claim 10, wherein the third length satisfies:

$$L_3 = \left\lceil \frac{N_3 \times (1-R) \times Rth3}{1-Rth3} \right\rceil_{Int},$$

wherein
$L_3$ indicates the third length, $N_3$ indicates the third codeword length, R indicates the reference coding rate of the LDPC codeword, $Rth3$ indicates the third preset coding rate threshold, and $[x]_{int}$ indicates rounding x.

12. The method according to any one of claims 9 to 11, wherein that the fourth length is determined based on a preset coding rate threshold comprises:
    the fourth length is determined based on the second codeword length and a fourth preset coding rate threshold, and the fourth preset coding rate threshold is less than the reference coding rate of the LDPC codeword.

13. The method according to claim 12, wherein the fourth length satisfies:

$$L_4 = \left\lceil \frac{N_2 \times Rth4}{1-Rth4} \right\rceil_{Int},$$

wherein
$L_4$ indicates the fourth length, $N_2$ indicates the second codeword length, $Rth4$ indicates the fourth preset coding rate threshold, and $[x]_{int}$ indicates rounding x.

**14.** The method according to any one of claims 10 to 13, wherein the third preset coding rate threshold is the same as the fourth preset coding rate threshold.

**15.** The method according to any one of claims 1 to 14, wherein the method further comprises:
transmitting, by the communication apparatus, the LDPC codeword, wherein the LDPC codeword comprises the to-be-encoded information bit and the parity bit.

**16.** The method according to any one of claims 1 to 15, wherein a number of shortening zero bits in the LDPC codeword is determined based on the length of the to-be-encoded information bit and a number of information bits in the LDPC codeword, and the number of information bits in the LDPC codeword is determined based on the length of the LDPC codeword and the reference coding rate.

**17.** The method according to claim 16, wherein the number of shortening zero bits in the LDPC codeword is as follows:

$$Padding\_Num = mod(K - mod(Inf\_Num, K), K),$$

wherein
Padding_Num indicates the number of shortening zero bits in the LDPC codeword, K indicates the number of information bits in the LDPC codeword, Inf_Num indicates the length of the to-be-encoded information bit, and mod indicates a modulo operation; and

$$K = N \times R,$$

wherein
N indicates the length of the LDPC codeword, and R indicates the reference coding rate of the LDPC codeword.

**18.** The method according to any one of claims 1 to 17, wherein the to-be-encoded information bit comprises a cyclic redundancy check CRC bit.

**19.** A method for determining a length of a low-density parity-check codeword in an ultra-wideband system, comprising:

obtaining, by a communication apparatus, a length of a to-be-encoded information bit; and
determining, by the communication apparatus, a length of a low-density parity-check LDPC codeword based on the length of the to-be-encoded information bit, wherein a parity-check matrix corresponding to the LDPC codeword is used to encode the to-be-encoded information bit to generate a parity bit, wherein
the length of the to-be-encoded information bit and the length of the LDPC codeword meet one or more of the following conditions: if the length of the to-be-encoded information bit is greater than a first value and less than or equal to a third length, the length of the LDPC codeword is 1944 bits; if the length of the to-be-encoded information bit is greater than the third length and less than or equal to a fourth length, the length of the LDPC codeword is 1296 bits; or if the length of the to-be-encoded information bit is greater than the fourth length, the length of the LDPC codeword is 1944 bits, wherein the first value is 648 bits or 81 bytes; and
at least one of the third length or the fourth length is determined based on a preset coding rate threshold.

**20.** The method according to claim 19, wherein a reference coding rate of the LDPC codeword is 1/2.

**21.** The method according to claim 19 or 20, wherein that the third length is determined based on a preset coding rate threshold comprises:
the third length is determined based on a third codeword length, the reference coding rate of the LDPC codeword, and a third preset coding rate threshold, the third codeword length is 1944 bits or 243 bytes, and the third preset coding rate threshold is less than the reference coding rate of the LDPC codeword.

**22.** The method according to claim 21, wherein the third length satisfies:

$$L_3 = \left\lceil \frac{N_3 \times (1 - R) \times Rth3}{1 - Rth3} \right\rceil_{Int},$$

wherein
$L_3$ indicates the third length, $N_3$ indicates the third codeword length, R indicates the reference coding rate of the LDPC codeword, $Rth3$ indicates the third preset coding rate threshold, and $[x]_{int}$ indicates rounding x.

23. The method according to any one of claims 19 to 22, wherein that the fourth length is determined based on a preset coding rate threshold comprises:
the fourth length is determined based on a second codeword length and a fourth preset coding rate threshold, the second codeword length is 1296 bits or 162 bytes, and the fourth preset coding rate threshold is less than the reference coding rate of the LDPC codeword.

24. The method according to claim 23, wherein the fourth length satisfies:

$$L_4 = \left[ \frac{N_2 \times Rth4}{1 - Rth4} \right]_{Int},$$

wherein
$L_4$ indicates the fourth length, $N_2$ indicates the second codeword length, $Rth4$ indicates the fourth preset coding rate threshold, and $[x]_{int}$ indicates rounding x.

25. The method according to any one of claims 21 to 24, wherein the third preset coding rate threshold is the same as the fourth preset coding rate threshold.

26. The method according to any one of claims 19 to 25, wherein the method further comprises:
transmitting, by the communication apparatus, the LDPC codeword, wherein the LDPC codeword comprises the to-be-encoded information bit and the parity bit.

27. The method according to any one of claims 19 to 26, wherein a number of shortening zero bits in the LDPC codeword is determined based on the length of the to-be-encoded information bit and a number of information bits in the LDPC codeword, and the number of information bits in the LDPC codeword is determined based on the length of the LDPC codeword and the reference coding rate.

28. The method according to claim 27, wherein the number of shortening zero bits in the LDPC codeword is as follows:

$$Padding\_Num = mod(K - mod(Inf\_Num, K), K),$$

wherein
Padding_Num indicates the number of shortening zero bits in the LDPC codeword, K indicates the number of information bits in the LDPC codeword, Inf_Num indicates the length of the to-be-encoded information bit, and mod indicates a modulo operation; and

$$K = N \times R,$$

wherein
N indicates the length of the LDPC codeword, and R indicates the reference coding rate of the LDPC codeword.

29. The method according to any one of claims 19 to 28, wherein the to-be-encoded information bit comprises a cyclic redundancy check CRC bit.

30. A communication apparatus, comprising:

an obtaining unit, configured to obtain a length of a to-be-encoded information bit; and
a determining unit, configured to determine a length of a low-density parity-check LDPC codeword based on the length of the to-be-encoded information bit, wherein a parity-check matrix corresponding to the LDPC codeword is used to encode the to-be-encoded information bit to generate a parity bit, wherein
the length of the to-be-encoded information bit and the length of the LDPC codeword meet one or more of the following conditions: if the length of the to-be-encoded information bit is greater than 0 and less than or equal to a first length, the length of the LDPC codeword is 648 bits; if the length of the to-be-encoded information bit is greater than the first length and less than or equal to a second length, the length of the LDPC codeword is 1296 bits; or if the length of the to-be-encoded information bit is greater than the second length and less than or equal to a first value, the length of the LDPC codeword is 1944 bits, wherein
at least one of the first length or the second length is determined based on a preset coding rate threshold.

31. The apparatus according to claim 30, wherein the apparatus further comprises a transmission unit, configured to transmit the LDPC codeword, wherein the LDPC codeword comprises the to-be-encoded information bit and the parity bit.

32. A communication apparatus, comprising:

    an obtaining unit, configured to obtain a length of a to-be-encoded information bit; and
    a determining unit, configured to determine a length of a low-density parity-check LDPC codeword based on the length of the to-be-encoded information bit, wherein a parity-check matrix corresponding to the LDPC codeword is used to encode the to-be-encoded information bit to generate a parity bit, wherein
    the length of the to-be-encoded information bit and the length of the LDPC codeword meet one or more of the following conditions: if the length of the to-be-encoded information bit is greater than a first value and less than or equal to a third length, the length of the LDPC codeword is 1944 bits; if the length of the to-be-encoded information bit is greater than the third length and less than or equal to a fourth length, the length of the LDPC codeword is 1296 bits; or if the length of the to-be-encoded information bit is greater than the fourth length, the length of the LDPC codeword is 1944 bits, wherein the first value is 648 bits or 81 bytes; and
    at least one of the third length or the fourth length is determined based on a preset coding rate threshold.

33. The apparatus according to claim 32, wherein the apparatus further comprises a transmission unit, configured to transmit the LDPC codeword, wherein the LDPC codeword comprises the to-be-encoded information bit and the parity bit.

34. A communication apparatus, comprising a processor and a memory, wherein

    the memory is configured to store instructions; and
    the processor is configured to execute the instructions, so that the method according to any one of claims 1 to 29 is performed.

35. A communication apparatus, comprising a logic circuit and an interface, wherein the logic circuit is coupled to the interface; and
    the interface is configured to input and/or output code instructions, and the logic circuit is configured to execute the code instructions, so that the method according to any one of claims 1 to 29 is performed.

36. A computer-readable storage medium, wherein the computer-readable storage medium is configured to store a computer program, and when the computer program is executed, the method according to any one of claims 1 to 29 is performed.

PAN coordinator

● Full function device

○ Reduced function device

FIG. 1

PAN coordinator

● Full function device

○ Reduced function device

FIG. 2

$$H=\begin{array}{c}V_1\ V_2\ V_3\ V_4\ V_5\ V_6\ V_7\ V_8\\\begin{bmatrix}1&0&1&0&1&0&1&0\\1&0&0&1&0&1&0&1\\0&1&1&0&0&1&1&0\\0&1&0&1&1&0&0&1\end{bmatrix}\begin{array}{c}C_1\\C_2\\C_3\\C_4\end{array}\end{array}$$

FIG. 3a

FIG. 3b

FIG. 4a

$$\begin{bmatrix} 0 & 1 & 0 & \dots & 0 \\ 0 & 0 & 1 & \dots & 1 \\ \vdots & \vdots & \vdots & \ddots & \vdots \\ 0 & 0 & 0 & \dots & 0 \\ 1 & 0 & 0 & \dots & 1 \end{bmatrix}$$

## FIG. 4b

FIG. 5

| 40 | - | - | - | 22 | - | 49 | 23 | 43 | - | - | - | 1 | 0 | - | - | - | - | - | - | - | - | - | - |
|----|---|---|---|----|---|----|----|----|---|---|---|---|---|---|---|---|---|---|---|---|---|---|---|
| 50 | 1 | - | - | 48 | 35 | - | - | 13 | - | 30 | - | - | 0 | 0 | - | - | - | - | - | - | - | - | - |
| 39 | 50 | - | - | 4 | - | 2 | - | - | - | - | 49 | - | - | 0 | 0 | - | - | - | - | - | - | - | - |
| 33 | - | - | 38 | 37 | - | - | 4 | 1 | - | - | - | - | - | 0 | 0 | - | - | - | - | - | - | - | - |
| 45 | - | - | - | 0 | 22 | - | - | 20 | 42 | - | - | - | - | - | 0 | 0 | - | - | - | - | - | - | - |
| 51 | - | - | 48 | 35 | - | - | - | 44 | - | 18 | - | - | - | - | - | 0 | 0 | - | - | - | - | - | - |
| 47 | 11 | - | - | - | 17 | - | - | 51 | - | - | - | 0 | - | - | - | - | 0 | 0 | - | - | - | - | - |
| 5 | - | 25 | - | 6 | - | 45 | - | 13 | 40 | - | - | - | - | - | - | - | - | 0 | 0 | - | - | - | - |
| 33 | - | - | 34 | 24 | - | - | - | 23 | - | - | 46 | - | - | - | - | - | - | - | 0 | 0 | - | - | - |
| 1 | - | 27 | - | 1 | - | - | - | 38 | - | 44 | - | - | - | - | - | - | - | - | - | 0 | 0 | - | - |
| - | 18 | - | - | 23 | - | - | 8 | 0 | 35 | - | - | - | - | - | - | - | - | - | - | - | 0 | 0 | - |
| 49 | - | 17 | - | 30 | - | - | - | 34 | - | - | 19 | 1 | - | - | - | - | - | - | - | - | - | - | 0 |

FIG. 6a

| | | | | | | | | | | | | | | | | | | | | | |
|---|---|---|---|---|---|---|---|---|---|---|---|---|---|---|---|---|---|---|---|---|---|
| 57 | - | - | - | 50 | - | 11 | - | 50 | - | 79 | - | 1 | 0 | - | - | - | - | - | - | - | - |
| 3 | - | 28 | - | 0 | - | - | - | 55 | 7 | - | - | - | 0 | 0 | - | - | - | - | - | - | - |
| 30 | - | - | - | 24 | 37 | - | - | 56 | 14 | - | - | - | - | 0 | 0 | - | - | - | - | - | - |
| 62 | 53 | - | - | 53 | - | - | 3 | 35 | - | - | - | - | - | 0 | 0 | - | - | - | - | - |
| 40 | - | - | 20 | 66 | - | - | 22 | 28 | - | - | - | - | - | - | 0 | 0 | - | - | - | - |
| 0 | - | - | - | 8 | - | 42 | - | 50 | - | - | 8 | - | - | - | - | 0 | 0 | - | - | - |
| 69 | 79 | 79 | - | - | - | 56 | - | 52 | - | - | - | 0 | - | - | - | - | 0 | 0 | - | - |
| 65 | - | - | - | 38 | 57 | - | - | 72 | - | 27 | - | - | - | - | - | - | 0 | 0 | - | - |
| 64 | - | - | - | 14 | 52 | - | - | 30 | - | - | 32 | - | - | - | - | - | - | 0 | 0 | - |
| - | 45 | - | 70 | 0 | - | - | - | 77 | 9 | - | - | - | - | - | - | - | - | 0 | 0 | - |
| 2 | 56 | - | 57 | 35 | - | - | - | - | - | 12 | - | - | - | - | - | - | - | - | 0 | 0 |
| 24 | - | 61 | - | 60 | - | - | 27 | 51 | - | - | 16 | 1 | - | - | - | - | - | - | - | 0 |

FIG. 6b

A communication apparatus obtains a length of a to-be-encoded information bit — S101

The communication apparatus determines a length of an LDPC codeword based on the length of the to-be-encoded information bit, where a parity-check matrix corresponding to the LDPC codeword is used to encode the to-be-encoded information bit to generate a parity bit, and the length of the to-be-encoded information bit and the length of the LDPC codeword meet one or more of the following conditions: if the length of the to-be-encoded information bit is greater than 0 and less than or equal to a first length, the length of the LDPC codeword is 648 bits; if the length of the to-be-encoded information bit is greater than the first length and less than or equal to a second length, the length of the LDPC codeword is 1296 bits; or if the length of the to-be-encoded information bit is greater than the second length and less than or equal to a first value, the length of the LDPC codeword is 1944 bits — S102

FIG. 7

EP 4 607 827 A1

Step 1

Payload bits

Step 2

\# of codewords and codeword size

| LDPC codeword | LDPC codeword | LDPC codeword |

Step 3    Shortening

| Payload bits | Shortening zero bits | |
| Payload bits | Shortening zero bits | |
| Payload bits | Shortening zero bits | |

Step 4    Parity

| Payload bits | Shortening zero bits | Parity bits |
| Payload bits | Shortening zero bits | Parity bits |
| Payload bits | Shortening zero bits | Parity bits |

Discard shortening bits

| Payload bits | Parity bits |
| Payload bits | Parity bits |
| Payload bits | Parity bits |

Payload bits: payload bits          LDPC codeword: LDPC codeword
Shortening zero bits: shortening zero bits        Shortening: shortening
Parity: parity      Parity bits: parity bits                Step: step
Discard shortening bits: discard shortening bits

FIG. 8

FIG. 9

EP 4 607 827 A1

FIG. 10

EP 4 607 827 A1

FIG. 11a

FIG. 11b

EP 4 607 827 A1

FIG. 11c

FIG. 12

A communication apparatus obtains a length of a to-be-encoded information bit    S201

The communications apparatus determines a length of an LDPC codeword based on the length of the to-be-encoded information bit, where a parity-check matrix corresponding to the LDPC codeword is used to encode the to-be-encoded information bit to generate a parity bit, and the length of the to-be-encoded information bit and the length of the LDPC codeword meet one or more of the following conditions: if the length of the to-be-encoded information bit is greater than a first value and less than or equal to a third length, the length of the LDPC codeword is 1944 bits; if the length of the to-be-encoded information bit is greater than the third length and less than or equal to a fourth length, the length of the LDPC codeword is 1296 bits; or if the length of the to-be-encoded information bit is greater than the fourth length, the length of the LDPC codeword is 1944 bits    S202

FIG. 13

FIG. 14

EP 4 607 827 A1

FIG. 15

FIG. 16

FIG. 17

## INTERNATIONAL SEARCH REPORT

International application No.

**PCT/CN2023/128092**

### A. CLASSIFICATION OF SUBJECT MATTER

H04L 1/00(2006.01)i

According to International Patent Classification (IPC) or to both national classification and IPC

### B. FIELDS SEARCHED

Minimum documentation searched (classification system followed by classification symbols)

IPC：H04L

Documentation searched other than minimum documentation to the extent that such documents are included in the fields searched

Electronic data base consulted during the international search (name of data base and, where practicable, search terms used)

CNTXT, ENTXT, DWPI, IEEE: 低密度奇偶校验, 码字, 长度, 信道, 编码, 超宽带, ldpc, code, length, ultra, wide, band, uwb

### C. DOCUMENTS CONSIDERED TO BE RELEVANT

| Category* | Citation of document, with indication, where appropriate, of the relevant passages | Relevant to claim No. |
|---|---|---|
| A | CN 113014268 A (MEDIATEK SINGAPORE PTE. LTD.) 22 June 2021 (2021-06-22) description, paragraphs 29-35 | 1-36 |
| A | CN 110166167 A (HUAWEI TECHNOLOGIES CO., LTD.) 23 August 2019 (2019-08-23) entire document | 1-36 |
| A | CN 113395132 A (HUAWEI TECHNOLOGIES CO., LTD.) 14 September 2021 (2021-09-14) entire document | 1-36 |
| A | US 2008008083 A1 (NOKIA CORP.) 10 January 2008 (2008-01-10) entire document | 1-36 |
| A | MANKAR. Monica et al. "REDUCED COMPLEXITY QUASI-CYCLIC LDPC ENCODER FOR IEEE 802.11N" *International Journal of VLSI design & Communication Systems (VLSICS),* 31 December 2016 (2016-12-31), entire document | 1-36 |

☐ Further documents are listed in the continuation of Box C.　　☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **19 January 2024** | **25 January 2024** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2023/128092**

| Patent document cited in search report | | | Publication date (day/month/year) | Patent family member(s) | | | Publication date (day/month/year) |
|---|---|---|---|---|---|---|---|
| CN | 113014268 | A | 22 June 2021 | DE | 102020133739 | A1 | 24 June 2021 |
| | | | | US | 2022368453 | A1 | 17 November 2022 |
| | | | | US | 2021194623 | A1 | 24 June 2021 |
| CN | 110166167 | A | 23 August 2019 | WO | 2019158031 | A1 | 22 August 2019 |
| CN | 113395132 | A | 14 September 2021 | WO | 2021180217 | A1 | 16 September 2021 |
| | | | | EP | 4109794 | A1 | 28 December 2022 |
| US | 2008008083 | A1 | 10 January 2008 | US | 7664008 | B2 | 16 February 2010 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202211350638
- CN 202211467840X